# EUROPEAN PATENT APPLICATION

(11) **EP 4 564 586 A1**
(43) Date of publication of application: **04.06.2025**
(21) Application number: 23857799.3
(22) Date of filing: 28.08.2023
(51) Int. Cl.: H01M 50/569, H04W 4/80, H01M 10/0587, H01M 50/538, H01M 50/46, H01M 50/107, H01M 50/167, H01M 50/186, G01L 1/14, H01M 10/42

(54) **CYLINDRICAL BATTERY COMPRISING PRESSURE SENSOR, APPARATUS FOR MONITORING SWELLING PRESSURE AND BATTERY MANAGEMENT SYSTEM COMPRISING SAME**

(30) Priority: 26.08.2022 KR 20220107706; 25.08.2023 KR 20230112248
(71) Applicant: LG Energy Solution, Ltd., Seoul 07335 (KR)
(72) Inventor: KWON, Yong-Hwan, Daejeon 34122 (KR); KIM, Dong-Wook, Daejeon 34122 (KR)
(74) Representative: Goddar, Heinz J.
(86) International application number: PCT/KR2023/012736
(87) International publication number: WO 2024/043767

(57) **Abstract**

Disclosed is a cylindrical battery including a pressure sensor, and an apparatus for monitoring a swelling pressure. The cylindrical battery includes an electrode assembly in which a first electrode, a second electrode, and a separator interposed therebetween are wound based on a winding axis to define a core and an outer circumference; a battery housing having an open end and a closed portion opposing thereto, configured to accommodate the electrode assembly in a space between the open end and the closed portion, and electrically connected to one of the first electrode and the second electrode to have a first polarity; a sealing body configured to seal the open end of the battery housing; a terminal electrically connected to another of the first electrode and the second electrode and having a surface exposed to an outside; and a pressure sensor interposed between an outer circumference of the electrode assembly and an inner circumference of the battery housing and configured to sense a swelling pressure applied by the outer circumference of the electrode assembly to the inner circumference of the battery housing and output a pressure sensing signal to the outside.

## Description

### TECHNICAL FIELD

The present disclosure relates to a cylindrical battery and an apparatus for monitoring a swelling pressure, and more particularly, to a cylindrical battery including a pressure sensor to sense a swelling pressure applied to a battery housing by an electrode assembly and transmit the sensed swelling pressure to the outside through wireless communication, an apparatus for monitoring a swelling pressure, and a battery management system including the same.

The present application claims priority to Korean Patent Application No. 10-2022-0107706 filed on August 26, 2022 in the Republic of Korea and Korean Patent Application No. 10-2023-0112248 filed on August 25, 2023 in the Republic of Korea, the disclosures of which are incorporated herein by reference.

### BACKGROUND ART

Secondary batteries that are easily applicable to various product groups and have electrical characteristics such as high energy density are universally applied not only to portable devices but also to electric vehicles (EVs), hybrid electric vehicles (HEVs) or plug-in hybrid electric vehicles (PHEVs) driven by a motor.

Hereinafter, an electric vehicle will be used as a term to refer to a vehicle that includes an electrically driven motor, such as EV, HEV, and PHEV.

These secondary batteries are attracting attention as a new energy source to improve eco-friendliness and energy efficiency because they have the primary advantage that they can dramatically reduce the use of fossil fuels as well as the secondary advantage that no byproducts are generated from the use of energy.

Secondary batteries currently widely used in the art include lithium ion batteries, lithium polymer batteries, nickel cadmium batteries, nickel hydrogen batteries, nickel zinc batteries, and the like. A unit secondary battery has an operating voltage of about 2.5V to 4.5V. Therefore, when a higher output voltage is required, a battery pack is configured by connecting a plurality of batteries in series. In addition, a plurality of batteries may be connected in parallel to form a battery pack according to the charge/discharge capacity required for the battery pack. Accordingly, the number of batteries included in the battery pack and the form of electrical connection may be variously set according to the required output voltage and/or charge/discharge capacity.

Meanwhile, as a kind of secondary battery, there are known cylindrical, rectangular, and pouch-type batteries. In the case of a cylindrical battery, a separator serving as an insulator is interposed between a positive electrode and a negative electrode, and they are wound to form an electrode assembly in the form of a jelly roll, which is inserted into a battery housing along with an electrolyte to configure a battery. In addition, a strip-shaped electrode tab may be connected to an uncoated portion of each of the positive electrode and the negative electrode, and the electrode tab electrically connects the electrode assembly and an electrode terminal exposed to the outside. For reference, in a cylindrical battery with a form factor of 1865, 2170, or the like, the positive electrode terminal is a cap of a sealing body that seals the opening of the battery housing, and the negative electrode terminal is the battery housing.

However, according to the conventional cylindrical battery, since current is concentrated in the strip-shaped electrode tab coupled to the uncoated portion of the positive electrode and/or the uncoated portion of the negative electrode, the current collection efficiency is not good due to large resistance and large heat generation.

For small cylindrical batteries with a form factor 1865, a form factor 2170, or the like, resistance and heat are not a major issue. However, when the form factor is increased to apply the cylindrical battery to an electric vehicle, the cylindrical battery may ignite while a lot of heat is generated around the electrode tab during the rapid charging process.

In order to solve this problem, there is provided a cylindrical battery (so-called tab-less cylindrical battery) in which the uncoated portion of the positive electrode and the uncoated portion of the negative electrode are designed to be positioned at the top and bottom of the jelly-roll type electrode assembly, respectively, and the current collector is welded to the uncoated portion to improve the current collecting efficiency.

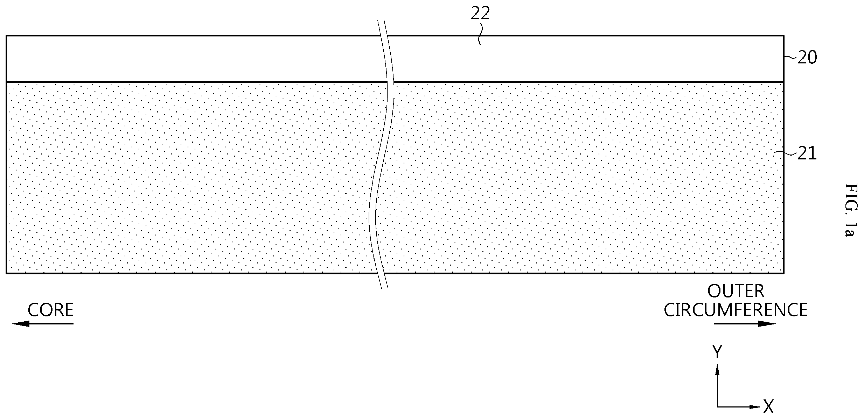

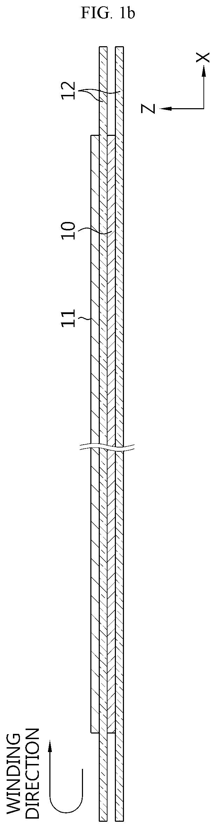

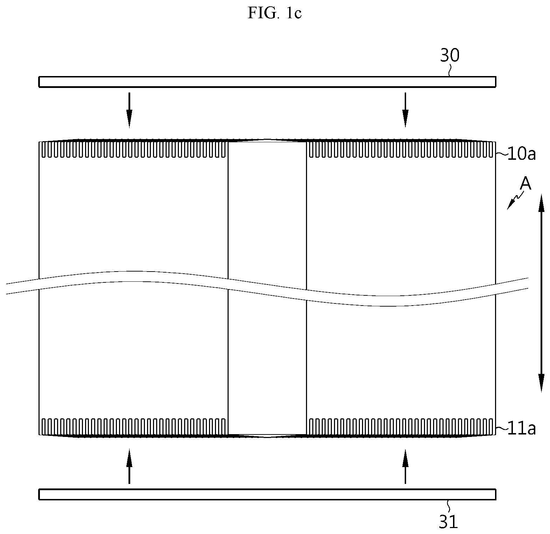

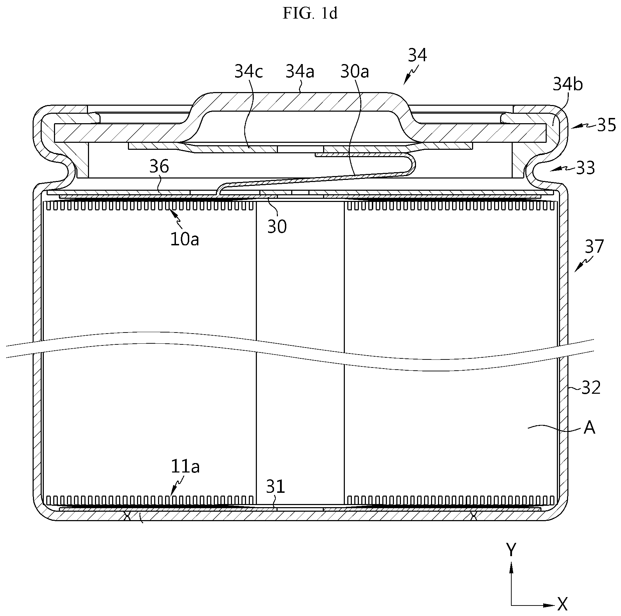

FIGS. 1a to 1c are diagrams showing a process of manufacturing a tab-less cylindrical battery. FIG. 1a shows the structure of an electrode, FIG. 1b shows a process of winding the electrode, and FIG. 1c shows a process of welding a current collector to a bent surface of an uncoated portion. FIG. 1d is a cross-sectional view showing the tab-less cylindrical battery, taken along the longitudinal direction Y.

Referring to FIGS. 1a to 1d, a positive electrode 10 and a negative electrode 11 have a structure in which a sheet-shaped current collector 20 is coated with an active material 21, and include an uncoated portion 22 at one long side along the winding direction X.

An electrode assembly A is manufactured by sequentially stacking the positive electrode 10 and the negative electrode 11 together with two sheets of separators 12 as shown in FIG. 1b and then winding them in one direction X. At this time, the uncoated portions of the positive electrode 10 and the negative electrode 11 are arranged in opposite directions.

After the winding process, the uncoated portion 10a of the positive electrode 10 and the uncoated portion 11a of the negative electrode 11 are bent toward the core. After that, current collectors 30, 31 are welded and coupled to the uncoated portions 10a, 11a, respectively.

An electrode tab is not separately coupled to the positive electrode uncoated portion 10a and the negative electrode uncoated portion 11a, the current collectors 30, 31 are connected to external electrode terminals, and a current path is formed with a large cross-sectional area along the winding axis direction of the electrode assembly A (see arrow, which has an advantage of lowering the resistance of the battery. This is because resistance is inversely proportional to the cross-sectional area of the path through which the current flows.

The electrode assembly A is inserted into the battery housing 32. The current collector 31 is welded to the bottom surface of the battery housing 32. At the upper portion of the edge of the current collector 30, the outer circumferential surface of the battery housing 32 is press-fitted to form the beading portion 33. The inner surface of the beading portion 33 presses the edge of the current collector 30. As a result, the electrode assembly A is firmly fixed inside the battery housing 32.

After the electrode assembly A is fixed inside the battery housing 32, electrolyte is injected into the battery housing 32. After that, the cap assembly 34 is coupled to the open portion of the battery housing 32.

The cap assembly 34 may include a cap 34a, a connection plate 34c coupled to the lower portion of the cap 34a, and a sealing gasket 34b that seals the periphery of the cap 34a and the open portion of the battery housing 32.

The upper portion of the beading portion 33 includes a crimping portion 35. The crimping portion 35 is formed by bending the open portion of the battery housing 32 inward, and seals the open portion of the battery housing 32 by pressing the sealing gasket 34b toward the edge surface of the cap 34a.

The current collector 30 and the connection plate 34c may be electrically connected by a lead 30a. The lead 30a may be manufactured as a separate part and coupled to the current collector 30, or may be manufactured integrally with the current collector 30 and extended to be coupled to the connection plate 34c.

An insulator 36 is disposed on the upper portion of the current collector 30. The edge of the insulator 36 may be interposed between the beading portion 33 and the current collector 30. Accordingly, the beading portion 33 presses the electrode assembly A toward the bottom of the battery housing 32 through the insulator 36.

Meanwhile, as the charging and discharging cycle of the cylindrical battery 37 increases, swelling phenomenon occurs and internal pressure increases. The swelling phenomenon refers to a phenomenon in which the volume of the active material coated on the positive electrode 10 and the negative electrode 11 increases as charging and discharging are repeated. The degree of swelling is relatively greater on the negative electrode 11. A cavity exists in the core of the electrode assembly A manufactured through the winding process as a trace of the core member inserted therein. Therefore, when the internal pressure of the cylindrical battery 37 increases due to swelling phenomenon, stress is concentrated toward the core of the electrode assembly A. Since the battery housing is made of a highly rigid metal, most of the stress is concentrated toward the core of the electrode assembly A where an empty space exists.

When stress occurs in the electrode assembly A due to the swelling phenomenon, the stress also acts in the circumferential direction, so the positive electrode 10 and the negative electrode 11 rotate slightly while sliding with the separator interposed therebetween. Also, as the charging and discharging cycle increases, the rotation amount of the positive electrode 10 and the negative electrode 11 accumulates to create a fine gap between the positive electrode 10 and the negative electrode 11 near the core, thereby causing a local change in curvature. Therefore, even if the electrode assembly A has good symmetry and circularity immediately after winding, if swelling phenomenon occurs, the symmetry and circularity of the electrode assembly A change unlike the first time.

In addition, if the swelling phenomenon intensifies in a state where the symmetry and circularity of the electrode assembly A are changed, a partial region of the core of the electrode assembly A cannot withstand the stress but collapse. In this process, the separator near the collapse area is torn or fine cracks are generated in the electrode, which causes an internal short circuit that is noted as the main cause of ignition accidents inside the cylindrical battery.

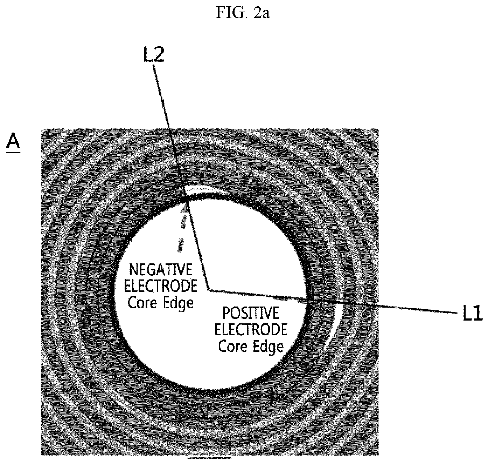

FIGS. 2a to 2c are cross-sectional views of the electrode assembly A schematically showing the process in which the core of the electrode assembly A collapses. Each cross-sectional view shows a plane cut perpendicular to the axial direction of the electrode assembly A.

FIG. 2a shows the core structure of the electrode assembly A when the cylindrical battery 37 is in the BOL (Beginning Of Life) state. Because a step is formed at the ends of the negative electrode and the positive electrode, circularity is lowered near the ends. In addition, when straight lines L1 and L2 are drawn from the center of the core through the end of the positive electrode and the end of the negative electrode, respectively, the winding turns of the electrodes located between L1 and L2 along the circumferential direction are not constant in curvature but change.

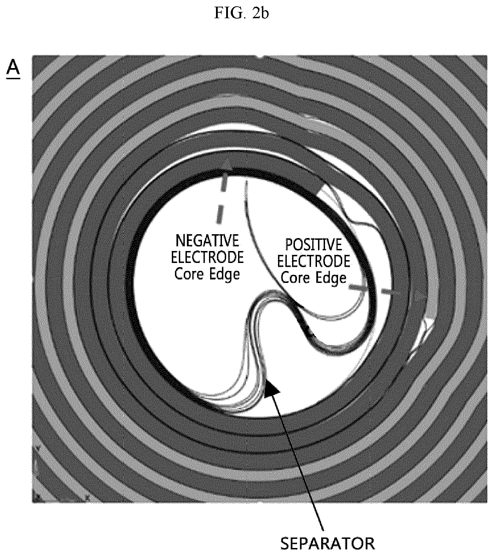

FIG. 2b shows a state in which the volume of the electrode, especially the negative electrode, increases as the charging and discharging cycle progresses for the cylindrical battery 37, so that the negative and positive electrodes are rotated near the core. The change in volume of the negative electrode is greatest at the first charge during the activation process for the cylindrical battery 37. This is because the chemicals that cause the electrochemical reaction move from the positive electrode to the negative electrode and are inserted into the negative electrode.

The core of the electrode assembly A has a hollow. Therefore, rotation of the electrode occurs mainly in the core. Of course, the electrode rotates slightly in the outer circumference of the electrode assembly A, but the degree of rotation is not significant compared to the core side. This is because a hollow exists in the core of the electrode assembly A, so when rotational stress occurs, the rotational freedom of the electrode is greater at the core than at the outer circumference of the electrode assembly A.

The increase in volume of the negative electrode is relatively larger than that of the positive electrode. Also, near the core of electrode assembly A, the positive electrode is sandwiched between the winding turns of the negative electrode, so a relatively greater frictional force acts on the surface of the positive electrode than on the surface of the negative electrode. Therefore, the rotation amount of the negative electrode is greater than the rotation amount of the positive electrode. This is because the larger the volume increase, the more rotational stress occurs, and the smaller the friction force, the more sliding occurs. In FIG. 2b, the rotation of the positive and negative electrodes may be found from the fact that the core side ends of the positive and negative electrodes rotate clockwise. The direction in which the electrode end rotates in the core of the electrode assembly is opposite to the winding direction.

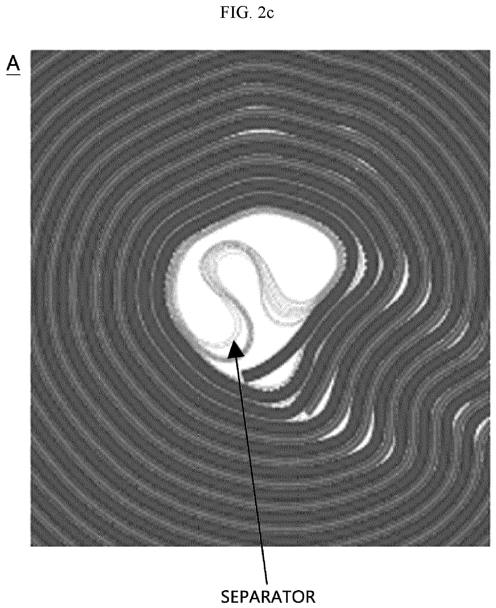

FIG. 2c shows the core structure when the swelling phenomenon intensifies as the charging and discharging cycle for the cylindrical battery 37 progresses hundreds of times. Due to the intensification of the swelling phenomenon, the end of the negative electrode rotates to the point where the end of the positive electrode is located. As a result, collapse occurred in the core area. When the core collapses, the structure of the winding turn, which had an arc shape convex outward, like the winding turns of the electrode located in the 3 o'clock to 6 o'clock direction, is transformed into a shape that is convex toward the core.

If the core of the electrode assembly A collapses as shown in FIG. 2c, the close contact between the positive electrode 10 and the negative electrode 11 is not maintained, a fine gap occurs at the interface between the electrodes, and the battery capacity suddenly decreases. Also, near the collapse area, the electrode and the separator collapse toward the core, causing the separator to tear or a fine crack to occur in the electrode, and thus the positive electrode 10 and the negative electrode 11 may contact each other, thereby causing an internal short circuit.

When the core of the electrode assembly A collapses, the capacity of the cylindrical battery B decreases, and also the possibility of ignition due to internal short circuit increases. Thus, it is preferable to stop the use of the cylindrical battery immediately if the core of the electrode assembly A collapses.

To achieve this, a technology is needed that may efficiently monitor the swelling pressure applied by the swollen electrode assembly A toward the inner circumference of the battery housing 32 while the cylindrical battery 37 is being charged and discharged.

### DISCLOSURE

### Technical Problem

The present disclosure is designed to solve the problems of the related art, and therefore the present disclosure is directed to providing a cylindrical battery including a pressure sensor to monitor a swelling pressure applied by a swollen electrode assembly on the inner circumference of a battery housing while the cylindrical battery is being charged and discharged.

The present disclosure is also directed to providing a cylindrical battery including a pressure sensor that may wirelessly transmit a pressure sensing signal to the outside, and an apparatus that may quantitatively monitor the swelling pressure of the cylindrical battery using the pressure sensor.

The present disclosure is also directed to providing a battery pack including the cylindrical battery with a pressure sensor, and a vehicle including the same.

The present disclosure is also directed to providing a battery management system that includes the apparatus for monitoring a swelling pressure of a cylindrical battery.

The technical objects of the present disclosure are not limited to the above, and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

In one aspect of the present disclosure, there is provided a cylindrical battery, comprising: an electrode assembly in which a first electrode, a second electrode, and a separator interposed therebetween are wound based on a winding axis to define a core and an outer circumference; a battery housing having an open end and a closed portion opposing thereto, configured to accommodate the electrode assembly in a space between the open end and the closed portion, and electrically connected to one of the first electrode and the second electrode to have a first polarity; a sealing body configured to seal the open end of the battery housing; a terminal electrically connected to another of the first electrode and the second electrode to have a second polarity and having a surface exposed to the outside; and a pressure sensor interposed between an outer circumference of the electrode assembly and an inner circumference of the battery housing and configured to sense a swelling pressure applied by the outer circumference of the electrode assembly to the inner circumference of the battery housing and output a pressure sensing signal to the outside.

The pressure sensor may be formed in a sheet shape and may be joined to the outer circumference of the electrode assembly along the shape of the outer circumference of the electrode assembly.

The first electrode may include a first active material portion coated with an active material layer and a first uncoated portion not coated with an active material layer along a winding direction, and the second electrode may include a second active material portion coated with an active material layer and a second uncoated portion not coated with an active material layer along the winding direction.

The first uncoated portion and the second uncoated portion may be exposed to the outside of the separator to face each other along the winding axis direction and may be defined by themselves as electrode tabs.

When a winding turn portion disposed between two straight lines connecting a center of the core to a core side end of the first active material portion and a core side end of the second active material portion on a cross section of the electrode assembly perpendicular to the winding axis direction is defined as a stress vulnerable region and a winding turn portion disposed between two straight lines connecting the center of the core to an outer circumference side end of the first active material portion and an outer circumference side end of the second active material portion is defined as a stress amplification region, the stress amplification region may be spaced apart from the stress vulnerable region along a circumferential direction of the electrode assembly on the cross section.

The pressure sensor may be interposed between the outer circumference of the electrode assembly and the inner circumference of the battery housing to cover at least a part of the stress amplification region.

The first electrode and the second electrode may be a positive electrode and a negative electrode, respectively. The outer circumference side end of the second electrode may be located closer to the outer circumference of the electrode assembly than the outer circumference side end of the first electrode. The separator may be interposed between the outer circumference side end of the second electrode and the outer circumference side end of the first electrode. The outer circumference side end of the second electrode may extend in the circumferential direction of the electrode assembly to pass through the outer circumference side end of the first electrode along the winding direction of the electrode assembly.

The pressure sensor may be interposed between the outer circumference of the electrode assembly and the inner circumference of the battery housing to intersect a straight line connecting the center of the core and the outer circumference side end of the first electrode.

The pressure sensor may output the pressure sensing signal to the outside through wireless communication.

The pressure sensor may include an energy conversion unit configured to convert mechanical energy by the swelling pressure into electrical energy; an energy storage unit configured to store the converted electrical energy as DC voltage; a pulse generation unit configured to receive the DC voltage from the energy storage unit and generate a surface acoustic wave in the form of a pulse; a detection unit whose capacitance varies depending on the pressure; and a transponder configured to generate a reference surface acoustic wave with the same amplitude as the surface acoustic wave and a sensing surface acoustic wave with an amplitude different from the reference surface acoustic wave according to a capacitance of the detection unit and output the reference surface acoustic wave and the sensing surface acoustic wave through an antenna.

The cylindrical battery may further comprise a first bending surface region formed by bending the first uncoated portion of the first electrode toward the core; a first current collector coupled to the first bending surface region; a second bending surface region formed by bending the second uncoated portion of the second electrode toward the core; and a second current collector coupled to the second bending surface region.

The sealing body may include a cap electrically connected to the first current collector; a crimping portion bent in a centripetal direction of the electrode assembly while surrounding an edge of the cap to fix the edge of the cap to the open end of the battery housing; and a sealing gasket interposed between the crimping portion and the edge of the cap to seal the open end of the battery housing.

The cylindrical battery may further comprise a rivet terminal riveted to an inner surface of the closed portion while passing through a perforation hole formed in the closed portion of the battery housing; and an insulating gasket interposed between the rivet terminal and an inner circumference of the perforation hole to electrically insulate the rivet terminal and the battery housing, and the terminal with a second polarity may be the rivet terminal.

The cylindrical battery may further comprise a beading portion formed by indenting the outer circumference of the battery housing adj acent to the open end of the battery housing toward the winding axis direction, and at least a part of an edge of the second current collector may contact the beading portion.

The cylindrical battery may further comprise a crimping portion formed by bending the open end of the battery housing toward the winding axis direction.

The sealing body may include a cap seated on the beading portion; and a sealing gasket interposed between an edge of the cap and the open end of the battery housing, and one surface of the sealing gasket may be in close contact with the edge of the cap by the crimping portion, and another surface of the sealing gasket may be in close contact with the edge of the second current collector in contact with the beading portion by the crimping portion.

A ratio of diameter to height of the cylindrical battery may be greater than 0.4.

The cylindrical battery may have a form factor of 46110, 4875, 48110, 4880, or 4680.

In another aspect of the present disclosure, there is also provided a battery pack comprising a cylindrical battery having at least one of the above features, and a vehicle comprising the battery pack.

In still another aspect of the present disclosure, there is also provided an apparatus for monitoring a swelling pressure of a cylindrical battery, comprising: a receiving unit configured to receive the pressure sensing signal transmitted from the pressure sensor through wireless communication; a signal processing unit configured to demodulate the pressure sensing signal into an original signal; and a control unit configured to determine a swelling pressure from the demodulated pressure sensing signal and generate time series data of the swelling pressure.

The pressure sensor may be configured to transmit a reference surface acoustic wave and a sensing surface acoustic wave having a different amplitude from the reference surface acoustic wave according to the swelling pressure through wireless communication.

The control unit may be configured to determine an amplitude difference between the reference surface acoustic wave and the sensing surface acoustic wave and determine a swelling pressure corresponding to the determined amplitude difference using a predefined correlation between the amplitude difference and the swelling pressure.

The control unit may be configured to generate a swelling pressure profile from the time series data of the swelling pressure, and when at least one minimal peak is identified in the swelling pressure profile, the control unit is configured to diagnoses that there is a sign of core collapse of the electrode assembly and output a diagnosis result.

The control unit may be configured to generate a swelling pressure profile from the time series data of the swelling pressure, generate a differential swelling pressure profile through time differentiation of the swelling pressure profile, diagnose that there is a sign of core collapse of the electrode assembly when at least one peak is identified in the differential swelling pressure profile, and output the diagnosis result.

The apparatus for monitoring a swelling pressure of a cylindrical battery may further comprise a voltage measuring unit configured to measure voltage of the cylindrical battery.

The control unit may be configured to generate a voltage profile by periodically receiving a voltage measurement value from the voltage measuring unit, generate a differential voltage profile through time or SOC differentiation for the voltage profile, and diagnose that there is a sign of core collapse of the electrode assembly when the swelling pressure is greater than or equal to a threshold value and at least one peak is identified in the differential voltage profile, and output the diagnosis result.

The apparatus for monitoring a swelling pressure of a cylindrical battery may further comprise a display unit and/or a communication unit operably coupled with the control unit.

The control unit may be configured to output the diagnosis result through the display unit.

The control unit may be configured to transmit the diagnosis result to a computer system through the communication unit.

The diagnosis result may include a warning message or an inspection request message.

In another aspect of the present disclosure, there is also provided a management system comprising an apparatus for monitoring a swelling pressure of a cylindrical battery having at least one of the above features.

### Advantageous Effects

According to an embodiment of the present disclosure, it is possible to prevent or alleviate the core from collapsing by maintaining the symmetry and circularity of the electrode assembly even if swelling phenomenon occurs by adjusting relative positions of a positive electrode end and a negative electrode end at the core and the outer circumference of the electrode assembly of the cylindrical battery.

According to another embodiment of the present disclosure, since a pressure sensor capable of transmitting a pressure sensing signal through wireless communication is included inside the cylindrical battery to continuously monitor the change in the swelling pressure that the outer circumference of the electrode assembly applies to the inner circumference of the battery housing, the sign of core collapse may be easily detected.

According to still another embodiment of the present disclosure, a battery pack manufactured using the cylindrical battery including a pressure sensor and a vehicle including the same may be provided.

According to still another embodiment of the present disclosure, an apparatus capable of monitoring the change in swelling pressure applied by the outer circumference of the electrode assembly to the inner circumference of the battery housing while a cylindrical battery is being charged and discharged and detecting the sign of core collapse of the electrode assembly, and a battery management system including the same may be provided.

In addition to the above effects, specific effects of the present disclosure will be described below while explaining the specific details for carrying out the present disclosure.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1a is a plan view showing a structure of an electrode used for a conventional tab-less cylindrical battery.
FIG. 1b is a diagram showing a process of winding an electrode assembly included in the conventional tab-less cylindrical battery.
FIG. 1c is a diagram showing a process of welding a current collector to a bent surface of an uncoated portion in the electrode assembly of FIG. 1b.
FIG. 1d is a cross-sectional view showing the conventional tab-less cylindrical battery, taken along the axial direction Y.
FIGS. 2a to 2c are cross-sectional views schematically showing the process in which the core of the electrode assembly according to the prior art collapses.
FIG. 3 is a cross-sectional view showing an electrode assembly according to an embodiment of the present disclosure, taken perpendicular to the axial direction Y.
FIG. 4 is a diagram for illustrating the relative positional relationship between a stress vulnerable region D1 and a stress amplification region D2 according to an embodiment of the present disclosure.
FIG. 5a is a diagram showing relative positions of a core side end (Aᵢₙₙₑᵣ) and an outer circumference side end (Aₒᵤₜₑᵣ) of the negative electrode and a core side end (Bᵢₙₙₑᵣ) and an outer circumference side end (Bₒᵤₜₑᵣ) of the positive electrode B according to an embodiment of the present disclosure.
FIG. 5b is a diagram showing relative positions of a core side end (Aᵢₙₙₑᵣ) and an outer circumference side end (Aₒᵤₜₑᵣ) of the negative electrode and a core side end (Bᵢₙₙₑᵣ) and an outer circumference side end (Bₒᵤₜₑᵣ) of the positive electrode B according to another embodiment of the present disclosure.
FIG. 5c is a diagram showing relative positions of a core side end (Aᵢₙₙₑᵣ) and an outer circumference side end (Aₒᵤₜₑᵣ) of the negative electrode and a core side end (Bᵢₙₙₑᵣ) and an outer circumference side end (Bₒᵤₜₑᵣ) of the positive electrode B according to still another embodiment of the present disclosure.
FIG. 6a is a diagram schematically showing a cross-section, taken perpendicular to an axial direction of a cylindrical battery including a pressure sensor (Pₛₑₙₛₒᵣ) according to an embodiment of the present disclosure.
FIG. 6b is a diagram schematically showing a portion of a cross section, taken along the axial direction of the cylindrical battery including the pressure sensor (Pₛₑₙₛₒᵣ) according to an embodiment of the present disclosure.
FIG. 6c is a diagram schematically showing the configuration of a pressure sensor (Pₛₑₙₛₒᵣ) according to an embodiment of the present disclosure.
FIG. 6d is a circuit diagram showing the circuit configuration of an energy storage unit according to an embodiment of the present disclosure.
FIG. 6e is a block diagram schematically showing the configuration of an apparatus for monitoring a swelling pressure of a cylindrical battery according to an embodiment of the present disclosure.
FIG. 6f is a graph showing a swelling pressure profile f(t,p) according to an embodiment of the present disclosure.
FIG. 6g is a graph showing a voltage profile g(t,V) according to an embodiment of the present disclosure.
FIG. 6h is a graph showing a voltage profile h(SOC,V) according to another embodiment of the present disclosure.
FIG. 7a is a plan view showing a structure of an electrode according to an embodiment of the present disclosure.
FIG. 7b is a plan view showing the structure of an electrode according to another embodiment of the present disclosure.
FIG. 7c is a plan view showing the structure of an electrode according to still another embodiment of the present disclosure.
FIG. 7d is a plan view showing the structure of an electrode according to still another embodiment of the present disclosure.
FIG. 7e is a plan view showing a modified structure of the electrode according to an embodiment of the present disclosure.
FIG. 7f is a top plan view showing an independent area in which a plurality of segments may be located when the electrode according to a modification of the present disclosure is wound into an electrode assembly.
FIG. 8 is a schematic diagram showing a cross section of a bending surface region formed by bending the segment toward the core of the electrode assembly according to an embodiment of the present disclosure.
FIG. 9 is a sectional view showing a cylindrical battery according to an embodiment of the present disclosure, taken along the Y-axis direction.
FIG. 10 is a sectional view showing a cylindrical battery according to another embodiment of the present disclosure, taken along the Y-axis direction.
FIG. 11 is a top plan view showing a state in which a plurality of cylindrical batteries are electrically connected.
FIG. 12 is a partially enlarged view of FIG. 11.
FIG. 13 is a diagram schematically showing a battery pack and a battery management system according to an embodiment of the present disclosure.
FIG. 14 is a diagram schematically showing a vehicle including the battery pack according to an embodiment of the present disclosure.

### BEST MODE

The above-mentioned purpose, features and advantages are described in detail later with reference to the attached drawings, and accordingly, a person skilled in the art in the technical field to which the present disclosure belongs will be able to easily implement the technical idea of the present disclosure. When explaining the present disclosure, if it is deemed that a detailed description of the publicly known technology related to the present disclosure may unnecessarily obscure the gist of the present disclosure, the detailed explanation is omitted. Hereinafter, a preferred embodiment according to the present disclosure will be described in detail with reference to the attached drawings. **In** the drawings, identical reference signs are used to indicate identical or similar components.

Although the terms first, second or the like are used to describe different elements, these elements are not limited by the terms. These terms are used to distinguish one element from another, and unless stated to the contrary, a first element may be a second element.

Throughout the specification, unless stated otherwise, each element may be singular or plural.

Hereinafter, when an element is "above (or under)" or "on (or below)" another element, the element can be on an upper surface (or a lower surface) of the other element, and intervening elements may be present between the element and the other element on (or below) the element.

Additionally, when an element is referred to as being "connected", "coupled" or "linked" to another element, the element can be directly connected or coupled to the other element, but it should be understood that intervening elements may be present between each element, or each element may be "connected", "coupled" or "linked" to each other through another element.

Singular expressions used in this specification include plural expressions unless the context clearly indicates otherwise. In this application, terms such as "including" or "comprising" should not be construed as necessarily including all of the various components or steps described in the specification, and it should be construed that some of the components or some of the steps may not be included, or additional components or steps may be further included.

Also, singular expressions used in this specification include plural expressions unless the context clearly indicates otherwise. In this application, terms such as "including" or "comprising" should not be construed as necessarily including all of the various components or steps described in the specification, and it should be construed that some of the components or some of the steps may not be included, or additional components or steps may be further included.

Throughout the specification, "A and/or B" refers to either A or B or both A and B unless expressly stated otherwise, and "C to D" refers to C or greater and D or smaller unless expressly stated otherwise.

For convenience of description, a direction that goes along a lengthwise direction of a winding axis of an electrode assembly wound in a roll shape is herein referred to as an axis direction Y. Additionally, a direction around the winding axis is herein referred to as a circumferential or peripheral direction X. Additionally, a direction that gets closer to or faces away from the winding axis is referred to as a radial or radiating direction Z. Among them, in particular, the direction that gets closer to the winding axis is referred to as a centripetal direction, and the direction that faces away from the winding axis is referred to as a centrifugal direction.

Hereinafter, a preferred embodiment of the present disclosure will be described with reference to the accompanying drawings.

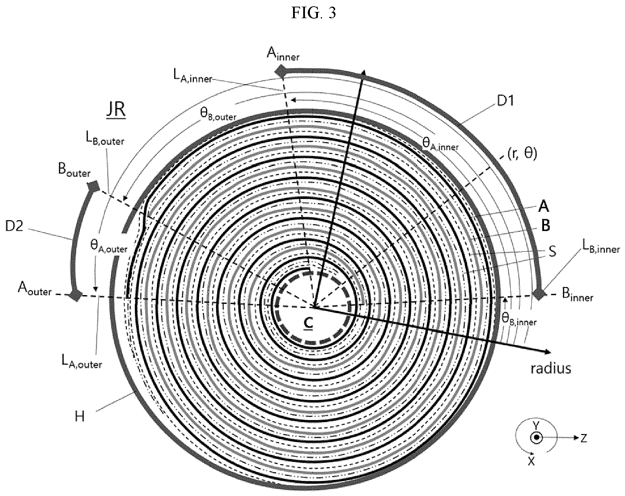

FIG. 3 is a cross-sectional view showing an electrode assembly JR according to an embodiment of the present disclosure, taken perpendicular to the axial direction Y.

Referring to FIG. 3, the electrode assembly JR according to the embodiment has a jelly-roll structure in which a negative electrode A and a positive electrode B are wound around one axis with a separator S interposed therebetween. The winding direction X is a counterclockwise direction, but may be replaced with a clockwise direction.

A hollow is formed in the core C of the electrode assembly JR. The hollow is an empty space. There are two separators S, as indicated by two-dot and chain lines, respectively. The arrangement structure of the separators S may be modified in various ways as long as they can insulate the negative electrode A and the positive electrode B from each other.

The winding structure of the negative electrode A, the positive electrode B, and the separator S in the electrode assembly JR is schematically shown. In the actual winding structure of the electrode assembly JR, the negative electrode A, the positive electrode B, and the separator S are in close contact with each other.

In the electrode assembly JR, the negative electrode A has a longer length in the winding direction X than the positive electrode B.

The winding turn of the negative electrode A starts before the winding turn of the positive electrode B. The winding turn of the positive electrode B begins after the winding turn of the negative electrode A increases by a predetermined number of turns. The winding turn of the negative electrode A, which does not face the positive electrode B, may be 1 to 5 turns. The winding turns near the core C, where only the negative electrode A is wound, reinforce the structural rigidity of the core. However, the winding turn where only the negative electrode A exists does not contribute to the capacity of the cylindrical battery. Therefore, the number of winding turns for only the negative electrode A may be appropriately selected considering the reinforcement of structural rigidity and the capacity. A plurality of winding turns formed by only the separator S may be provided inside the winding turn formed by only the negative electrode A. The winding turn formed by only the separator S may also reinforce the structural rigidity of the core.

First, a structure that optimizes the end positions of the negative electrode A and the positive electrode B in order to prevent or alleviate the core of the electrode assembly JR from collapsing due to rotational stress resulting from the swelling phenomenon is disclosed.

The ends of the negative electrode A and the positive electrode B refer to a core side end and an outer circumference side end of the winding turn structure of the negative electrode A and the positive electrode B.

In the present disclosure, for convenience of explanation, an embodiment in which the end positions of the negative electrode A and the positive electrode B are optimized by applying a two-dimensional polar coordinate system on a cross-section perpendicular to the axial direction of the electrode assembly JR will be described.

When a two-dimensional polar coordinate system is applied to the cross-section structure of the electrode assembly JR, the position within the cross-section structure may be expressed as a distance (r) measured from the center of the polar coordinate system to the corresponding position and an angle measured to the corresponding position in the circumferential direction (counterclockwise) based on the X-axis.

Even if the angle measurement direction of the position is changed to the clockwise direction, the technical idea of the present disclosure can be applied practically in the same way.

Referring to FIG. 3, the angle of the core side end (Aᵢₙₙₑᵣ) and the angle of the outer circumference side end (Aₒᵤₜₑᵣ) of the negative electrode A may be expressed as θ_{A,inner} and θ_{A,outer}, respectively.

Similarly, the angle of the core side end (Bᵢₙₙₑᵣ) and the angle of the outer circumference side end (Bₒᵤₜₑᵣ) of the positive electrode B may be expressed as θ_{B,inner} and θ_{B,outer}, respectively.

According to one aspect, when the negative electrode A and the positive electrode B are wound counterclockwise, as the charging and discharging cycle is repeated, the core side end (Aᵢₙₙₑᵣ) of the negative electrode A and the core side end (Bᵢₙₙₑᵣ) of the positive electrode B rotate clockwise. The rotation amount is relatively large when the initial cycle (in particular, full charge in the activation process) is performed, and in the subsequent charging and discharging cycles, the rotation amount gradually decreases and converges close to 0.

The swelling amount of the negative electrode A is relatively larger than that of the positive electrode B. Therefore, the rotation amount of the core side end (Aᵢₙₙₑᵣ) of the negative electrode A is greater than the rotation amount of the core side end (Bᵢₙₙₑᵣ) of the positive electrode B.

In one example, the rotation amount of the core side end (Aᵢₙₙₑᵣ) of the negative electrode A may be several tens of degrees, and the rotation amount of the core side end (Bᵢₙₙₑᵣ) of the positive electrode B may be less than ten degrees.

As the charging and discharging cycle repeats, the outer circumference side end (Aₒᵤₜₑᵣ) of the negative electrode A and the outer circumference side end (Bₒᵤₜₑᵣ) of the positive electrode B rotate counterclockwise. The rotation amount is relatively large during the initial charging and discharging cycle, and is small to be less than a few degrees in subsequent charging and discharging cycles.

The swelling amount of the negative electrode A is relatively larger than that of the positive electrode B. Therefore, the rotation amount of the outer circumference side end (Aₒᵤₜₑᵣ) of the negative electrode A is greater than the rotation amount of the outer circumference side end (Bₒᵤₜₑᵣ) of the positive electrode B.

According to another aspect, the winding turn portion located between a straight line (L_{A,inner}) connecting from the center of the core C of the electrode assembly JR to the core side end (Aᵢₙₙₑᵣ) of the negative electrode A and a straight line (L_{B,inner}) connecting from the center of the core C of the electrode assembly JR to the core side end (Bᵢₙₙₑᵣ) of the positive electrode B has reduced circularity near the core C, and thus is vulnerable to stress applied to the core C when the electrode assembly JR is swollen.

According to another aspect, the winding turn portion located between a straight line (L_{A,outer}) connecting from the center of the core C of the electrode assembly JR to the outer circumference side end (Aₒᵤₜₑᵣ) of the negative electrode A and a straight lines (L_{B,outer}) connecting from the center of the core C of the electrode assembly JR to the outer circumference side end (Bₒᵤₜₑᵣ) of the positive electrode B amplifies the stress applied to the core C when the electrode assembly JR is swollen. The reason is that the winding turn portion where the outer circumference side end (Bₒᵤₜₑᵣ) of the positive electrode B is located contains the most electrode and separator layers in the radial direction, so when the electrode assembly JR swells, the winding turn portion where the outer circumference side end (Bₒᵤₜₑᵣ) of the positive electrode B is located and the outer circumference side end (Aₒᵤₜₑᵣ) of the negative electrode A adjacent thereto more early contact the battery housing H than other outer circumference regions and are pressed the most, which increases the stress applied to the core C as much.

According to the experiment, the gap between the electrode assembly JR and the battery housing H is very small, so when the one to three charging and discharging cycles proceed, the winding turn portion where the outer circumference side end (Bₒᵤₜₑᵣ) of the positive electrode B is located already begins to contact the inner circumference of the battery housing H. Also, once the winding turn portion where the outer circumference side end (Bₒᵤₜₑᵣ) of the positive electrode B is located begins to contact the battery housing H, as the swelling of the electrode assembly JR deepens, the corresponding winding turn portion is getting more and more pressured toward the inner circumference of the battery housing H. Therefore, when the charging and discharging cycle is repeated, the outer circumference side end (Aₒᵤₜₑᵣ) of the negative electrode A and the outer circumference side end (Bₒᵤₜₑᵣ) of the positive electrode B are substantially fixed without meaningfully rotating. In addition, if the charging and discharging cycle continues to be repeated, the degree of pressing (compression) at the outer circumference side end (Bₒᵤₜₑᵣ) of the positive electrode B becomes more severe, so that the corresponding point amplifies the stress the most.

Hereinafter, for convenience of explanation, the winding turn portion located between the straight lines L_{A,inner} and L_{B,inner} is defined as a stress vulnerable region D1, and the winding turn portion located between the straight lines L_{A,inner} and L_{B,inner} is defined as a stress amplification region D2.

According to still another aspect, during the effective use period of the cylindrical battery, namely from BOL (Beginning Of Life, shipping time point) to EOL (End Of Life, life required by the customer), the angle and position of the stress vulnerable region D1 and the stress amplification region D2 are changed.

The EOL may be defined as the number of charging and discharging cycles. The EOL may be 200 cycles, 300 cycles, 400 cycles, 500 cycles, 600 cycles, 700 cycles, 800 cycles, 900 cycles, or more cycles.

The EOL may be defined as a capacity retention rate. The EOL may be defined as a capacity retention rate of 90%, a capacity retention rate of 85%, a capacity retention rate of 80%, or a lower capacity retention rate.

The cylindrical battery that has reached EOL may be replaced or used for other purposes.

In order to prevent or alleviate the collapse of the core C during the effective use period of the cylindrical battery, it is desirable to optimally design the relative positions of the stress vulnerable region D1 and the stress amplification region D2 so that the stress vulnerable region D1 and the stress amplification region D2 may be spaced apart from each other at a predetermined angle in the circumferential direction.

Alternatively, to prevent or alleviate the collapse of the core C during the effective use period of the cylindrical battery, it is desirable to optimally design the relative positions of the stress vulnerable region D1 and the stress amplification region D2 so that the outer circumference side end (Bₒᵤₜₑᵣ) of the positive electrode B in the stress amplification region D2 may be spaced apart from the stress vulnerable region D1 at a predetermined angle in the circumferential direction.

The relative positions of the stress vulnerable region D1 and the stress amplification region D2 may be optimized by adjusting the positions of the core side end (Aᵢₙₙₑᵣ) of the negative electrode A and the core side end (Bᵢₙₙₑᵣ) of the positive electrode B, and the positions of the outer circumference side end (Aₒᵤₜₑᵣ) of the negative electrode A and the outer circumference side end (Bₒᵤₜₑᵣ) of the positive electrode B.

In one embodiment, the positions of the core side end (Aᵢₙₙₑᵣ) of the negative electrode A and the core side end (Bᵢₙₙₑᵣ) of the positive electrode B may be appropriately designed so that |θ_{A,inner}- θ_{B,inner}|, which corresponds to the circumferential angle between the core side end (Aᵢₙₙₑᵣ) of the negative electrode A and the core side end (Bᵢₙₙₑᵣ) of the positive electrode B, maintains an angle between 30 degrees to 180 degrees during the effective use period of the cylindrical battery.

When designing the positions of the core side end (Aᵢₙₙₑᵣ) of the negative electrode A and the core side end (Bᵢₙₙₑᵣ) of the positive electrode B, the total rotation amount for the ends (Aᵢₙₙₑᵣ, Bᵢₙₙₑᵣ) of both electrodes may be taken into consideration. The total rotation amount may be determined in advance through a charging and discharging cycle experiment of the cylindrical battery.

In a specific example, the positions of the core side end (Aᵢₙₙₑᵣ) of the negative electrode A and the core side end (Bᵢₙₙₑᵣ) of the positive electrode B may be set appropriately so that |θ_{A,inner}- θ_{B,inner}| maintains an angle of 40 degrees or less, 50 degrees or less, 60 degrees or less, and 70 degrees or less, 80 degrees or less, 90 degrees or less, 100 degrees or less, 120 degrees or less, 130 degrees or less, 140 degrees or less, 150 degrees or less, 160 degrees or less, 170 degrees or less, or 180 degrees or less during the effective use period of the cylindrical battery.

In another embodiment, the positions of the core side end (Aᵢₙₙₑᵣ) of the negative electrode A and the core side end (Bᵢₙₙₑᵣ) of the positive electrode B may be set appropriately so that |θ_{A,inner}- θ_{B,inner}|, which corresponds to the circumferential angle between the core side end (Aᵢₙₙₑᵣ) of the negative electrode A and the core side end (Bᵢₙₙₑᵣ) of the positive electrode B, may converge to a specific angle selected in the range of 30 degrees or more and less than 180 degrees during the effective use period of the cylindrical battery.

In a specific example, the positions of the core side end (Aᵢₙₙₑᵣ) of the negative electrode A and the core side end (Bᵢₙₙₑᵣ) of the positive electrode B may be set appropriately so that |θ_{A,inner}- θ_{B,inner}| converges to 30 degrees, 40 degrees, 50 degrees, 60 degrees, 70 degrees, 80 degrees, 90 degrees, 100 degrees, 110 degrees, 120 degrees, 130 degrees, 140 degrees, 150 degrees, 160 degrees, or 170 degrees during the effective use period of the cylindrical battery.

In a preferred example, the positions of the core side end (Aᵢₙₙₑᵣ) of the negative electrode A and the core side end (Bᵢₙₙₑᵣ) of the positive electrode B may be set appropriately so that |θ_{A,inner}- θ_{B,inner}| converges to the range of 110 degrees to 130 degrees, preferably to the range of 115 degrees to 125 degrees, more preferably to 120 degrees during the effective use period of the cylindrical battery.

As described above, the negative electrode A is longer than the positive electrode B in the winding direction X, and the positive electrode B is located inner than the negative electrode A in the winding direction X. Therefore, the angle (θ_{A,outer}) of the outer circumference side end (Aₒᵤₜₑᵣ) of the negative electrode A is greater than the angle (θ_{B,outer}) of the outer circumference side end (Bₒᵤₜₑᵣ) of the positive electrode B.

That is, the outer circumference side end (Aₒᵤₜₑᵣ) of the negative electrode A may be located closer to the outer circumference of the electrode assembly JR than the outer circumference side end (Bₒᵤₜₑᵣ) of the positive electrode B, and may be extended longer in the circumferential direction by passing through the outer circumference side end (Bₒᵤₜₑᵣ) of the positive electrode B along the winding direction X. The separator S is interposed between the outer circumference side end (Aₒᵤₜₑᵣ) of the negative electrode A and the outer circumference side end (Bₒᵤₜₑᵣ) of the positive electrode B.

In the embodiment, the positions of the outer circumference side end (Aₒᵤₜₑᵣ) of the negative electrode A and the outer circumference side end (Bₒᵤₜₑᵣ) of the positive electrode B may be designed so that |θ_{A,outer}- θ_{B,outer}| corresponding to the difference between the angle (θ_{A,outer}) of the outer circumference side end (Aₒᵤₜₑᵣ) of the negative electrode A and the angle (θ_{B,outer}) of the outer circumference side end (Bₒᵤₜₑᵣ) of the positive electrode B may be maintained in the range of 10 degrees to 90 degrees during the effective use period of the cylindrical battery.

When the electrode assembly JR swells, in order to alleviate the imbalance of stress applied to the core C, |θ_{A,outer}- θ_{B,outer}| may be designed to be smaller than θ_{A,inner}- θ_{B,inner}|.

**In** specific examples, the positions of the outer circumference side end (Aₒᵤₜₑᵣ) of the negative electrode A and the outer circumference side end (Bₒᵤₜₑᵣ) of the positive electrode B may be designed so that |θ_{A,outer}- θ_{B,outer}| may maintain an angle of 90 degrees or less, 80 degrees or less, 70 degrees or less, 60 degrees or less, 50 degrees or less, 40 degrees or less, 30 degrees or less, or 20 degrees or less during the effective use period of the cylindrical battery.

In another embodiment, the positions of the outer circumference side end (Aₒᵤₜₑᵣ) of the negative electrode A and the outer circumference side end (Bₒᵤₜₑᵣ) of the positive electrode B may be designed so that |θ_{A,outer}- θ_{B,outer}| corresponding to the difference between the angle (θ_{A,outer}) of the outer circumference side end (Aₒᵤₜₑᵣ) of the negative electrode A and the angle (θ_{B,outer}) of the outer circumference side end (Bₒᵤₜₑᵣ) of the positive electrode B may converge to a specific angle selected in the range of 10 degrees to 90 degrees during the effective use period of the cylindrical battery.

In a specific example, the positions of the outer circumference side end (Aₒᵤₜₑᵣ) of the negative electrode A and the outer circumference side end (Bₒᵤₜₑᵣ) of the positive electrode B may be designed so that |θ_{A,outer}- θ_{B,outer}| may converge to an angle of 90 degrees, 80 degrees, 70 degrees, 60 degrees, 50 degrees, 40 degrees, 30 degrees, 20 degrees, or 10 degrees during the effective use period of the cylindrical battery.

In a more specific example, the positions of the outer circumference side end (Aₒᵤₜₑᵣ) of the negative electrode A and the outer circumference side end (Bₒᵤₜₑᵣ) of the positive electrode B may be designed so that |θ_{A,outer}- θ_{B,outer}| may maintain an angle of 10 degrees to 40 degrees or converge to a specific angle selected in the range of 10 degrees to 40 degrees during the effective use period of the cylindrical battery.

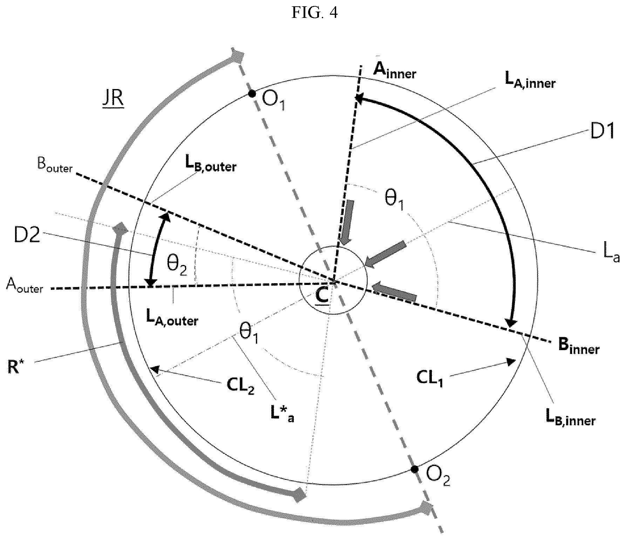

FIG. 4 is a diagram for illustrating the relative positional relationship between a stress vulnerable region D1 and a stress amplification region D2 according to an embodiment of the present disclosure.

Referring to FIG. 4, the stress vulnerable region D1 has a circumferential angle (θ₁). In addition, the stress amplification region D2 has a circumferential angle (θ₂).

When the line segment that divides the circumferential angle (θ₁) of the stress vulnerable region D1 into two equal angles is defined as Lₐ and the diametric line segment perpendicular to the line segment Lₐ and passing through the center of the core C of the electrode assembly JR is defined as O₁O₂, the cross-section of the electrode assembly JR may be classified into a first semicircular region (CL₁) and a second semicircular region (CL₂) facing each other based on the diametric line segment O₁O₂.

As the stress amplification region D2 becomes closer to the stress vulnerable region D1 in the circumferential direction, the probability of collapsing of the core C increases in the stress vulnerable region D1.

Therefore, the relative positions of the core side end (Aᵢₙₙₑᵣ) of the negative electrode A, the core side end (Bᵢₙₙₑᵣ) of the positive electrode B, the outer circumference side end (Aₒᵤₜₑᵣ) of the negative electrode A and the outer circumference side end (Bₒᵤₜₑᵣ) of the positive electrode B may be set in advance at the winding stage of the electrode assembly JR, so that the stress amplification region D2 is located within the second semicircular region (CL₂) defined based on the stress vulnerable region D1, even if the stress vulnerable region D1 rotates during the effective use period of the cylindrical battery.

According to this design, the stress applied to the core C in the stress vulnerable region D1 does not overlap with the stress applied to the core C in the stress amplification region D2, thereby to prevent the stress from increasing beyond a critical level. Here, the critical level may be the stress level that causes collapse of the core C in the stress vulnerable region D1.

Preferably, in terms of stress distribution, the location of the stress amplification region D2 is preferably designed so that at least a part of the stress applied to the core C in the stress vulnerable region D1 and the stress applied to the core C in the stress amplification region D2 face each other.

Therefore, the relative positions of the core side end (Aᵢₙₙₑᵣ) of the negative electrode A, the core side end (Bᵢₙₙₑᵣ) of the positive electrode B, the outer circumference side end (Aₒᵤₜₑᵣ) of the negative electrode A and the outer circumference side end (Bₒᵤₜₑᵣ) of the positive electrode B may be set in advance at the winding stage of the electrode assembly JR, so that, even if the core side end (Aᵢₙₙₑᵣ) of the negative electrode A and the core side end (Bᵢₙₙₑᵣ) of the positive electrode B rotate during the effective use period of the cylindrical battery, the stress amplification region D2 is located within the second semicircular region (CL₂) defined based on the stress vulnerable region D1, and a part or all of the stress amplification region D2 overlaps with the fan-shaped region (R*) that is point symmetrical with the stress vulnerable region D1 based on the core C.

Alternatively, the relative positions of the core side end (Aᵢₙₙₑᵣ) of the negative electrode A, the core side end (Bᵢₙₙₑᵣ) of the positive electrode B, the outer circumference side end (Aₒᵤₜₑᵣ) of the negative electrode A and the outer circumference side end (Bₒᵤₜₑᵣ) of the positive electrode B may be set in advance at the winding stage of the electrode assembly JR, so that, even if the core side end (Aᵢₙₙₑᵣ) of the negative electrode A and the core side end (Bᵢₙₙₑᵣ) of the positive electrode B rotate during the effective use period of the cylindrical battery, the stress amplification region D2 is located within the second semicircular region (CL₂) defined based on the stress vulnerable region D1, and the outer circumference side end (Bₒᵤₜₑᵣ) of the positive electrode B is located on the arc of the third fan-shaped region (R*) and overlaps therewith.

More preferably, the relative positions of the core side end (Aᵢₙₙₑᵣ) of the negative electrode A, the core side end (Bᵢₙₙₑᵣ) of the positive electrode B, the outer circumference side end (Aₒᵤₜₑᵣ) of the negative electrode A and the outer circumference side end (Bₒᵤₜₑᵣ) of the positive electrode B may be set in advance at the winding stage of the electrode assembly JR, so that, even if the core side end (Aᵢₙₙₑᵣ) of the negative electrode A and the core side end (Bᵢₙₙₑᵣ) of the positive electrode B rotate during the effective use period of the cylindrical battery, the stress amplification region D2 is located within the second semicircular region (CL₂) defined based on the stress vulnerable region D1, and the stress amplification region D2 overlaps with the straight line that divides the circumferential angle of the fan-shaped region (R*) into two equal angles.

More preferably, the relative positions of the core side end (Aᵢₙₙₑᵣ) of the negative electrode A, the core side end (Bᵢₙₙₑᵣ) of the positive electrode B, the outer circumference side end (Aₒᵤₜₑᵣ) of the negative electrode A and the outer circumference side end (Bₒᵤₜₑᵣ) of the positive electrode B may be set in advance at the winding stage of the electrode assembly JR, so that, even if the core side end (Aᵢₙₙₑᵣ) of the negative electrode A and the core side end (Bᵢₙₙₑᵣ) of the positive electrode B rotate during the effective use period of the cylindrical battery, the stress amplification region D2 is located within the second semicircular region (CL₂) defined based on the stress vulnerable region D1, and the outer circumference side end (Bₒᵤₜₑᵣ) of the positive electrode B overlaps with the straight line that divides the circumferential angle of the fan-shaped region (R*) into two equal angles.

According to the above designs, since the symmetry of the stress applied to the core C is improved as at least part of the stress applied to the core C in the stress amplification region D2 is opposed to the stress applied to the core C in the stress vulnerable region D1, it is possible to prevent the core C from collapsing or alleviate the phenomenon of collapsing of the core C.

According to still another aspect of the present disclosure, depending on the relative positions of the core side end (Aᵢₙₙₑᵣ) of the negative electrode A, the core side end (Bᵢₙₙₑᵣ) of the positive electrode B, the outer circumference side end (Aₒᵤₜₑᵣ) of the negative electrode A and the outer circumference side end (Bₒᵤₜₑᵣ) of the positive electrode B, the speed at which a portion of the outer circumference of the electrode assembly corresponding to the outer circumference side end (Bₒᵤₜₑᵣ) of the positive electrode B contacts the inner circumference of the battery housing may vary.

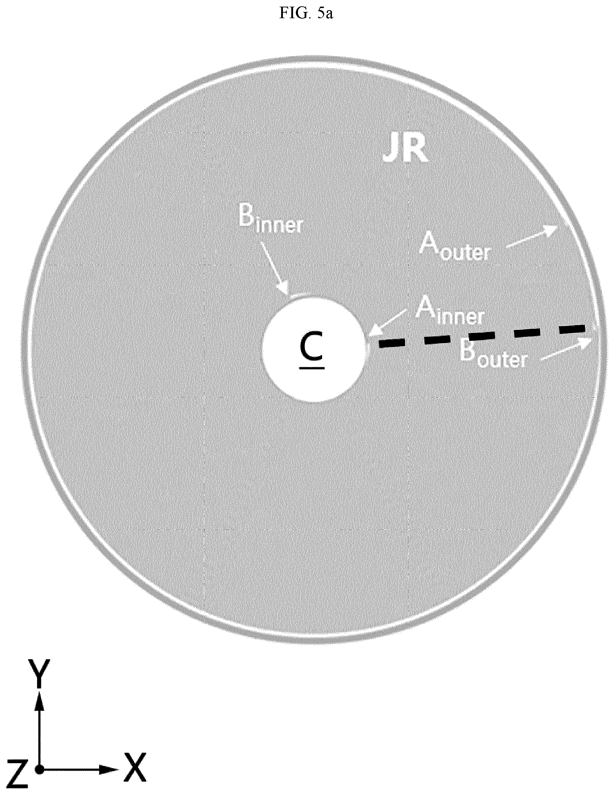

FIGS. 5a to 5c are sectional views of cylindrical batteries showing three different embodiments for the relative positions of a core side end (Aᵢₙₙₑᵣ) and an outer circumference side end (Aₒᵤₜₑᵣ) of the negative electrode and a core side end (Bᵢₙₙₑᵣ) and an outer circumference side end (Bₒᵤₜₑᵣ) of the positive electrode B.

The electrode assembly JR shown in FIGS. 5a to 5c has specifications that can be used in a cylindrical battery with a form factor of 4680 (diameter: 46 mm, height: 80 mm).

When the cylindrical battery in FIG. 5a is in the BOL state, the core side end (Aᵢₙₙₑᵣ) of the negative electrode A and the outer circumference side end (Bₒᵤₜₑᵣ) of the positive electrode B are located on the same line in the radial direction of the electrode assembly JR.

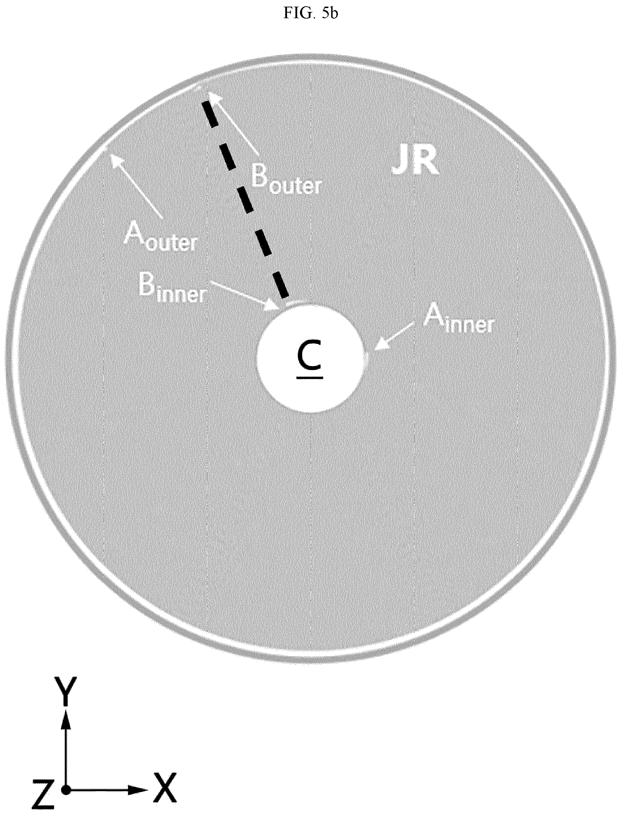

When the cylindrical battery in FIG. 5b is in the BOL state, the core side end (Bᵢₙₙₑᵣ) of the positive electrode B and the outer circumference side end (Bₒᵤₜₑᵣ) of the positive electrode B are located on the same line in the radial direction of the electrode assembly JR.

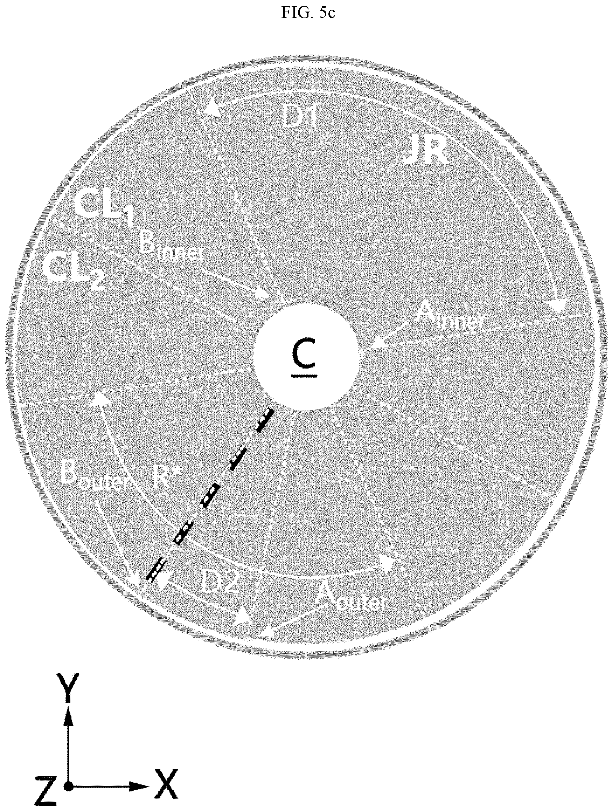

When the cylindrical battery in FIG. 5c is in the BOL state, the stress amplification region D2 is located within the second semicircular region (CL₂) defined based on the stress vulnerable region D1, and is located to overlap with approximately the center of the fan-shaped region (R*) that is point symmetrical with the stress vulnerable region D1.

When the cylindrical battery of FIG. 5a and the cylindrical battery of FIG. 5b are repeatedly charged and discharged, the outer circumference side end (Bₒᵤₜₑᵣ) of the positive electrode B begins to contact the inner surface of the battery housing H at the point where the volume of the negative electrode A increases by about 2.5%.

Meanwhile, when the cylindrical battery of FIG. 5c is repeatedly charged and discharged, the outer circumference side end (Bₒᵤₜₑᵣ) of the positive electrode B begins to contact the inner surface of the battery housing H at the point where the volume of the negative electrode A increases by about 5%.

Like the cylindrical battery in FIG. 5c, if the point at which the outer circumference side end (Bₒᵤₜₑᵣ) of the positive electrode B contacts the inner surface of the battery housing H is delayed, this means that the circularity of the cross-section of the electrode assembly JR is relatively well maintained.

Like the cylindrical battery in FIG. 5c, if the circularity of the electrode assembly cross-section is maintained relatively well, the possibility of collapse of the core may be reduced compared to the cylindrical battery in FIGS. 5a and 5b, even if the charging and discharging cycle is increased.

Meanwhile, the cylindrical battery according to the present disclosure may include a pressure sensor (Pₛₑₙₛₒᵣ) that may sense the swelling pressure applied to the inner circumference of the battery housing H by the outer circumference of the electrode assembly JR when the electrode assembly JR is swollen, and provide a pressure sensing signal to the outside.

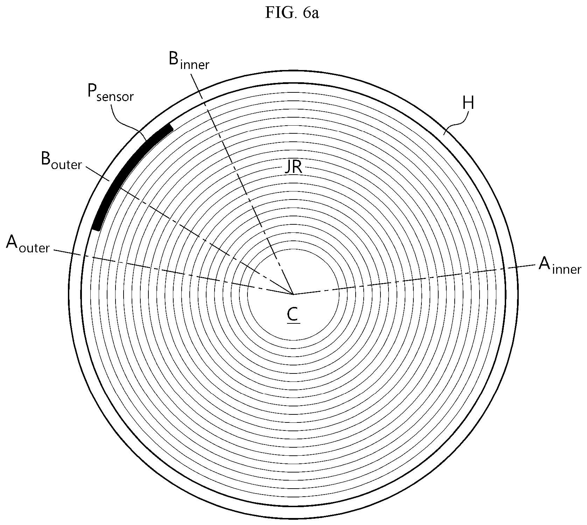

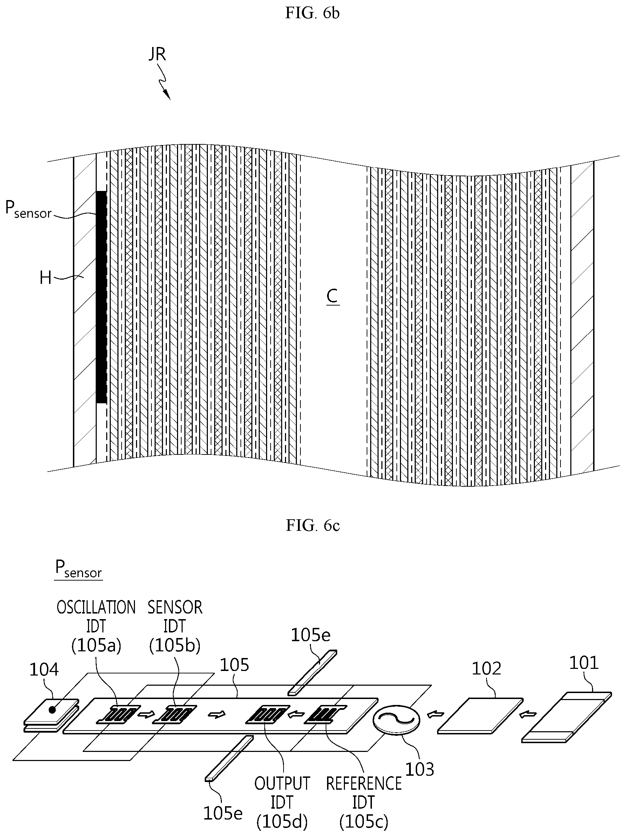

FIG. 6a is a diagram schematically showing a cross-section, taken perpendicular to an axial direction of a cylindrical battery including a pressure sensor (Pₛₑₙₛₒᵣ) according to an embodiment of the present disclosure. Also, FIG. 6b is a diagram schematically showing a portion of a cross section, taken along the axial direction of the cylindrical battery including the pressure sensor (Pₛₑₙₛₒᵣ) according to an embodiment of the present disclosure.

Referring to FIGS. 6a and 6b, the pressure sensor (Pₛₑₙₛₒᵣ) may be interposed between the outer circumference of the electrode assembly JR and the battery housing H. The pressure sensor (Pₛₑₙₛₒᵣ) may be attached to the outer circumference of the electrode assembly JR using an adhesive or an adhesive tape according to the shape of the outer circumference of the electrode assembly JR.

The area where the outer circumference side end (Bₒᵤₜₑᵣ) of the positive electrode is located first contacts the inner circumference of the battery housing H when the electrode assembly JR is swollen, so the greatest swelling pressure is applied to the inner circumference of the battery housing H where the outer circumference side end (Bₒᵤₜₑᵣ) of the positive electrode contacts.

In one aspect, the pressure sensor (Pₛₑₙₛₒᵣ) may be interposed between the outer circumference of the electrode assembly JR and the inner circumference of the battery housing H so as to intersect a straight line connecting the core center of the electrode assembly JR and the outer circumference side end (Bₒᵤₜₑᵣ) of the positive electrode.

In another aspect, the pressure sensor (Sₑₙₛₒᵣ) may be interposed between the outer circumference of the electrode assembly JR and the inner circumference of the battery housing H to simultaneously intersect the straight lines connecting from the core center of the electrode assembly JR to the outer circumference side end (Bₒᵤₜₑᵣ) of the positive electrode and the outer circumference side end (Aₒᵤₜₑᵣ) of the negative electrode, respectively.

In still another aspect, the pressure sensor (Sₑₙₛₒᵣ) may be interposed between the outer circumference of the electrode assembly JR and the inner circumference of the battery housing H so that the pressure sensor (Sₑₙₛₒᵣ) overlaps with at least a part of the stress amplification region D2 (FIG. 3).

Even if power is not applied from the outside, the pressure sensor (Pₛₑₙₛₒᵣ) may measure the swelling pressure applied by the outer circumference of the electrode assembly JR to the inner circumference of the battery housing H and transmit a pressure sensing signal to the outside through wireless communication.

FIG. 6c is a diagram schematically showing the configuration of a pressure sensor (Pₛₑₙₛₒᵣ) according to an embodiment of the present disclosure.

Referring to FIG. 6c, the pressure sensor (Pₛₑₙₛₒᵣ) has a sheet shape and may include an energy conversion unit 101, an energy storage unit 102, a pulse generation unit 103, a detection unit 104, and a transponder 105.

The pressure sensor (Pₛₑₙₛₒᵣ) may be surrounded by a thin and transparent insulation film. Preferably, the pressure sensor (Pₛₑₙₛₒᵣ) may be interposed between the upper insulation film and the lower insulation film. There are no particular restrictions on the insulation film as long as it is made of a transparent and insulating material. The insulation film may be a polyethylene terephthalate (PET) film or a polyimide (PI) film.

The energy conversion unit 101 is a piezoelectric generator that converts mechanical energy due to pressure into electrical energy, and generates voltage by the force applied to the piezoelectric material. The magnitude of the voltage is proportional to the magnitude of the applied force. The voltage generated in the energy conversion unit 101 is applied to the energy storage unit 102. The piezoelectric generator may alternatively use conventionally used piezoelectric elements.

The energy storage unit 102 transforms the voltage generated in the energy conversion unit 101 to an appropriate level of voltage, then rectifies the voltage, and stores the voltage as a DC voltage.

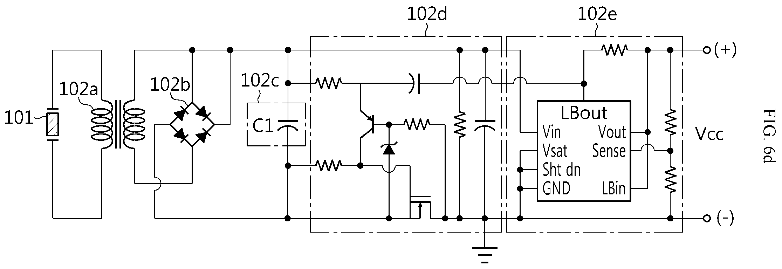

FIG. 6d is a circuit diagram showing the circuit configuration of the energy storage unit 102 according to an embodiment of the present disclosure.

Referring to FIG. 6d, the voltage generated in the energy conversion unit 101 is lowered to an appropriate level in the transformer 102a, then rectified as a full wave through the bridge rectifier 102b, and charged to the capacitor C1, 102c as a DC voltage. The voltage charged in the capacitor C1 is boosted in the boosting circuit 102d, then adjusted to a voltage (Vcc) capable of driving the pulse generation unit 103 by the voltage adjustment unit 102e, and output to the pulse generation unit 103. When the capacitor C1 is charged to a preset level, the energy storage unit 102 releases the stored electrical energy to drive the pulse generation unit 103. Therefore, the pulse generation unit 103 may be driven repeatedly at time intervals.

Referring again to FIG. 6c, the pulse generation unit 103 is a voltage controlled oscillator (VCO) that generates an RF signal with an oscillation frequency adjusted according to the voltage (Vcc) output from the energy storage unit 102 and applies the RF signal to the transponder 105 to induce surface acoustic waves to be generated in the transponder 105. The pulse generation unit 103 induces a surface acoustic wave by generating an RF signal on its own without receiving a wireless RF signal from the outside. Preferably, the transponder 105 may be a SAW transponder.

The detection unit 104 is a variable capacitance type pressure sensing device using MEMS (Micro Electro Mechanical System) technology. The capacitance is variable depending on the pressure applied from the outside, and the impedance for the sensor IDT (InterDigital Transducer) 105b of the transponder 105 changes depending on the degree of variation of the capacitance. That is, the impedance for the sensor IDT 105b changes depending on the pressure applied to the detection unit 104, and the amplitude of the surface acoustic wave passing through the sensor IDT 105b changes according to the change in impedance. Therefore, the pressure applied to the detection unit 40 may be known by calculating how much the amplitude has changed. When the pressure sensor (Pₛₑₙₛₒᵣ) is disposed, it is desirable that the surface of the detection unit 104 is perpendicular to the direction in which the swelling pressure is applied.

The transponder 105 receives an RF signal from the pulse generation unit 103, generates a surface acoustic wave, and outputs a pressure sensing signal measured by the surface acoustic wave as a wireless signal through the antenna 105e. In other words, the transponder 105 does not receive an RF signal from the outside and generate a surface acoustic wave like a conventional transponder, but rather generates electrical energy using the energy conversion unit 101 provided in the sensor and then generates a RF signal internally using the electrical energy to generate a surface acoustic wave. The transponder 105 may include a plurality of IDT metal electrodes arranged in parallel on a substrate (LiNbO₃) having piezoelectric properties.

The transponder 105 includes a launching IDT 105a, a sensor IDT 105b, a reference IDT 105c, an output IDT 105d, and an antenna 105e.

The launching IDT 105a receives the RF signal from the pulse generator 103, converts the RF signal into a surface acoustic wave, and outputs the surface acoustic wave to the sensor IDT 105b.

The sensor IDT 105b is electrically connected to the detection unit 104, and is installed on the path of the wave along which the surface acoustic wave generated by the launching IDT 105a is applied to the output IDT 105d between the launching IDT 105a and the output IDT 105d. In other words, the surface acoustic wave generated in the launching IDT 105a passes through the sensor IDT 105b and is applied to the output IDT 105d. At this time, if a swelling pressure is applied to the detection unit 104 so that the capacitance of the detection unit 104 changes, the impedance of the sensor IDT 105b changes accordingly. Accordingly, the amplitude of the surface acoustic wave passing through the sensor IDT 105b changes.

The reference IDT 105c is installed in a direction opposite to the launching IDT 105a based on the output IDT 105d, and when receiving the RF signal from the pulse generator 103, the reference IDT 105c converts the RF signal into a surface acoustic wave and outputs the surface acoustic wave to the output IDT 105d. At this time, the surface acoustic wave generated by the reference IDT 105c has the same amplitude as the surface acoustic wave generated by the launching IDT 105a. The surface acoustic wave generated in the reference IDT 105c is a surface acoustic wave that serves as a standard for comparing how much the amplitude of the surface acoustic wave generated in the launching IDT 105a has changed in the sensor IDT 105b according to the swelling pressure applied to the detection unit 104. Therefore, the launching IDT 105a and the reference IDT 105c are designed so that the surface acoustic waves generated by the two IDTs 105a, 105c have the same amplitude. Also, the distance between the reference IDT 105c and the output IDT 105d is designed to be shorter than the distance between the launching IDT 105a and the output IDT 105d.

The output IDT 105d converts the surface acoustic waves applied from the reference IDT 105c and the sensor IDT 105b into RF signals, respectively, and the converted RF signals are transmitted wirelessly to the apparatus for monitoring a swelling pressure at the outside through the antenna 105e.

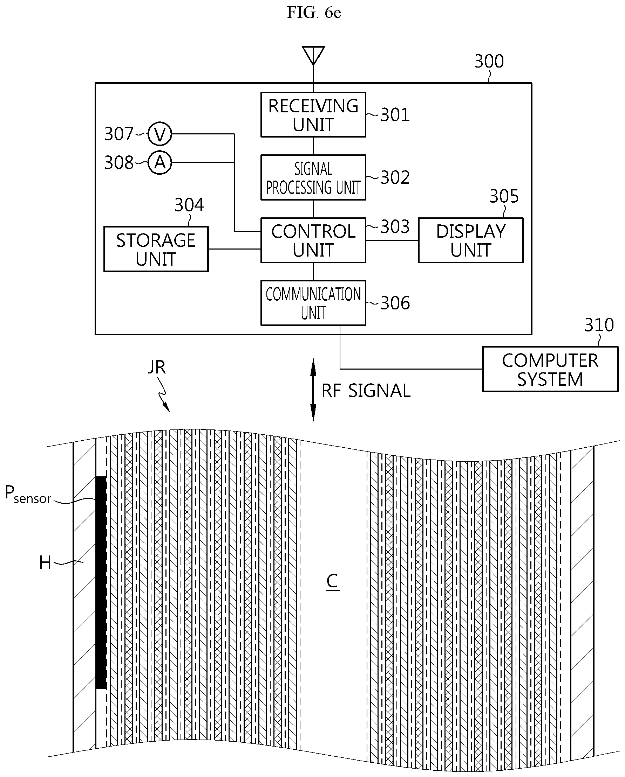

The apparatus 300 for monitoring a swelling pressure (FIG. 6e) at the outside may sequentially receive the RF signal corresponding to the surface acoustic wave generated in the reference IDT 105c and the RF signal corresponding to the surface acoustic wave generated in the launching IDT 105a, and then quantitatively detect the size of the swelling pressure applied to the detection unit 104 by processing the received RF signals and comparing their amplitudes.

The pressure sensor (Pₛₑₙₛₒᵣ) operates as follows. If a swelling pressure is applied to the energy conversion unit 101, the energy conversion unit 101 converts the mechanical energy caused by the swelling pressure into electrical energy and outputs the electrical energy. The electrical energy generated in the energy conversion unit 101 is charged to the capacitor C1 of the energy storage unit 102. If the capacitor C1 is charged to a predetermined level, the energy storage unit 102 releases the stored electrical energy to the pulse generator 103 to drive the pulse generator 103.

If the pulse generator 103 receives electrical energy from the energy storage unit 102, the pulse generator 103 adjusts the oscillation frequency according to the voltage level of the supplied electrical energy and generates an RF signal according to the corresponding frequency. The RF signal generated from the pulse generator 103 is applied to the reference IDT 105c and the launching IDT 105a, respectively.

If an RF signal is applied, the reference IDT 105c and the launching IDT 105a convert the RF signal into a surface acoustic wave and output the surface acoustic wave. At this time, the surface acoustic wave generated by the reference IDT 105c (hereinafter, referred to as 'reference surface acoustic wave') and the surface acoustic wave generated by launching IDT 105a (hereinafter, referred to as 'sensing surface acoustic wave') have the same amplitude.

The reference surface acoustic wave and the sensing surface acoustic wave generated by the reference IDT 105c and the launching IDT 105a, respectively, are applied to the output IDT 105d. That is, the reference surface acoustic wave generated in the reference IDT 105c is directly applied to the output IDT 105d, and the surface acoustic wave generated in the launching IDT 105a is applied to the output IDT 105d through the sensor IDT 105b. At this time, because the distance between the reference IDT 105c and the output IDT 105d (the travel distance of the reference surface acoustic wave) is shorter than the distance between the launching IDT 105a and the output IDT 105d (the travel distance of the sensing surface acoustic wave), the reference surface acoustic wave is applied to the output IDT 105d before the sensing surface acoustic wave.

Accordingly, the reference surface acoustic wave generated in the reference IDT 105c is first converted into a reference RF signal in the output IDT 105d and then wirelessly transmitted to the apparatus 300 for monitoring a swelling pressure at the outside through the antenna 105e. At this time, since the reference surface acoustic wave does not pass through other IDT metals during its progress, the waveform generated by the reference IDT 105c is maintained.

Next, the sensing surface acoustic wave generated in the launching IDT 105a is applied to the output IDT 105d, converted into a sensing RF signal, and then wirelessly transmitted to the apparatus 300 for monitoring a swelling pressure at the outside through the antenna 105e. Since the sensor IDT 105b exists between the launching IDT 105a and the output IDT 105d, the amplitude of the sensing surface acoustic wave changes as it passes through the sensor IDT 105b on the way to the output IDT 105d, unlike the reference surface acoustic wave. The degree of change in amplitude varies depending on the impedance of the sensor IDT 105b, namely the size of the capacitance that varies depending on the swelling pressure applied to the detection unit 104. In other words, the capacitance of the detection unit 104 changes depending on the size of the swelling pressure applied to the detection unit 104, and the amplitude of the sensing surface acoustic wave changes depending on the degree of change.

The sensing surface acoustic wave whose amplitude is varied by the sensor IDT 105b is converted into a sensing RF signal at the output IDT 105d and transmitted to the apparatus 300 for monitoring a swelling pressure at the outside through the antenna 105e. The apparatus 300 for monitoring a swelling pressure at the outside may quantitatively calculate the magnitude of the swelling pressure applied to the detection unit 104 by processing the sensing RF signal corresponding to the sensing surface acoustic wave and the reference RF signal corresponding to the previously arrived reference surface acoustic wave and then comparing the amplitudes of the two processed signals to calculate the difference.

FIG. 6e is a block diagram schematically showing the configuration of the apparatus 300 for monitoring a swelling pressure of a cylindrical battery according to an embodiment of the present disclosure.

Referring to FIG. 6e, the apparatus 300 for monitoring a swelling pressure of a cylindrical battery may include a receiving unit 301, a signal processing unit 302, a control unit 303, a storage unit 304, a display unit 305, and a communication unit 306.

The receiving unit 301 is a circuit that may receive an RF signal through an antenna, and receives a pressure sensing signal transmitted wirelessly from the pressure sensor (Pₛₑₙₛₒᵣ) and transmits the pressure sensing signal to the signal processing unit 302. The pressure sensing signal includes a reference RF signal and a sensing RF signal that sequentially arrive at the antenna. The pressure sensing signal may be repeatedly received whenever electrical energy of a certain level or above is stored in the energy storage unit 102 of the pressure sensor (Pₛₑₙₛₒᵣ).

The signal processing unit 302 is a circuit that removes noise from the signal received through wireless communication and restores the original signal, and generates a sensing surface acoustic wave and a reference surface acoustic wave by demodulating the reference RF signal and the sensing RF signal, respectively, and input them to the control unit 303. The sensing surface acoustic wave and the reference surface acoustic wave correspond to signals generated from the pressure sensor (Pₛₑₙₛₒᵣ). Here, RF circuit technology for demodulating an RF signal into an original signal is widely known in the art, and thus not described in detail here.

The control unit 303 is a circuit that controls the apparatus 300 for monitoring a swelling pressure of a cylindrical battery on the whole. The control unit 303 may determine the amplitude of the sensing surface acoustic wave and the amplitude of the reference surface acoustic wave through signal processing and determine the difference between the two amplitudes. Also, the control unit 303 may determine the swelling pressure corresponding to the difference between the two amplitudes by referring to a look-up table in which the swelling pressure according to the difference in amplitude between the sensing surface acoustic wave and the reference surface acoustic wave is defined in advance. The look-up table may be recorded in the storage unit 304 in advance and referenced by the control unit 303.

The control unit 303 may also generate time series data of the swelling pressure in the storage unit 304 by accumulatively recording the determined swelling pressure together with a time stamp in the storage unit 304. The length of the time interval in which the time series data of the swelling pressure is generated may be set arbitrarily. Also, the control unit 303 may generate a swelling pressure profile using the time series data of the swelling pressure stored in the storage unit 304.

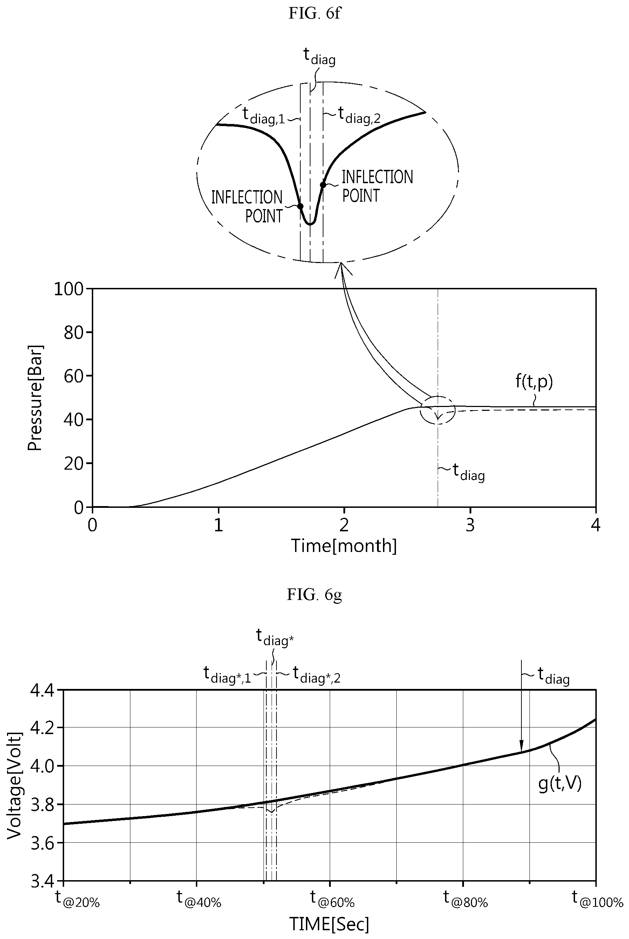

FIG. 6f is a graph showing a swelling pressure profile f(t,p) according to an embodiment of the present disclosure. In f(t,p), t is a variable representing time and p is a variable representing a swelling pressure.

Referring to the swelling pressure profile f(t,p) shown in FIG. 6f, the swelling pressure gradually increases over time and reaches a saturation state. The section where the swelling pressure increases is the section where the outer diameter of the battery housing H increases as the battery housing H is elastically deformed due to swelling of the electrode assembly JR. Meanwhile, the section after the swelling pressure reaches saturation is the section where the battery housing H undergoes plastic deformation as the swelling of the electrode assembly JR becomes more severe. If the battery housing H undergoes plastic deformation, the battery housing H is not restored to its original shape even if the electrode assembly JR is removed from the battery housing H.

The core collapse phenomenon of the electrode assembly JR may occur after the swelling pressure reaches saturation in the swelling pressure profile f(t,p). If there is a sign of core collapse in the electrode assembly JR, an abnormal pattern may appear where the swelling pressure suddenly decreases for a short period of time and then slowly increases again, as shown by the dotted line profile. In other words, if at least one minimal peak is identified in the swelling pressure profile f(t,p), it may be diagnosed that there is a sign of core collapse of the electrode assembly JR. If there is a sign of collapse of the core of the electrode assembly JR, the stress within the electrode assembly JR slightly decreases and the swelling pressure suddenly and slightly decreases for a short period of time. Therefore, the control unit 303 may detect the sign of core collapse of the electrode assembly JR in advance using the swelling pressure profile f(t,p).

In one embodiment, the control unit 303 may periodically generate the swelling pressure profile f(t,p) as shown in FIG. 6f using the time series data of the swelling pressure stored in the storage unit 304. Also, when at least one minimal peak is identified in the swelling pressure profile f(t,p), the control unit 303 may diagnose that there is a sign of core collapse of the electrode assembly JR and output a diagnosis result.

In another embodiment, the control unit 303 may generate a differential swelling pressure profile f'(t,p) through time differentiation with respect to the swelling pressure profile f(t,p) as shown in FIG. 6f. If a minimal peak appears at the t_{diag} time point in the swelling pressure profile f(t,p), a minimal peak may appear at the t_{diag,1} time point before the t_{diag} time point and a maximal peak may appear at the time point t_{diag,2} after the t_{diag} time point in the differential swelling pressure profile f'(t,p). This is because, in the swelling pressure profile f(t,p), an inflection point occurs at the t_{diag,1} time point and the t_{diag,2} time point before and after the t_{diag} time point where the minimal peak appears. Therefore, if at least one peak is identified in the differential swelling pressure profile f'(t,p), the control unit 303 may diagnose that there is a sign of core collapse of the electrode assembly JR and output a diagnosis result. According to this embodiment, the sign of core collapse of the electrode assembly JR may be detected at the t_{diag,1} time point, which is earlier than the t_{diag} time point.

In another embodiment, the control unit 303 may monitor the voltage of the battery as well as the swelling pressure at the same time to detect in advance the sign of core collapse of the electrode assembly JR. For this purpose, the apparatus 300 for monitoring a swelling pressure of a cylindrical battery may further include a voltage measuring unit 307. The voltage measuring unit 307 includes a voltage measurement circuit known in the art.

The control unit 303 may generate time series data of the voltage in the storage unit 304 by periodically receiving the voltage measurement value from the voltage measuring unit 307 and storing the voltage measurement value cumulatively in the storage unit 304 along with a time stamp. The length of the time section in which the time series data of the voltage is generated may be arbitrarily set.

The control unit 303 may periodically generate a voltage profile g(t,V) using the time series data of the voltage stored in the storage unit 304. In g(t,V), t is a variable representing time and V is a variable representing voltage.

FIG. 6g is a graph showing a voltage profile g(t,V) according to an embodiment of the present disclosure.

The control unit 303 may generate a differential voltage profile g'(t,V) through time differentiation with respect to the voltage profile g(t,V).

The control unit 303 may detect the sign of core collapse of the electrode assembly JR in advance using the periodically generated differential voltage profile g'(t,V).

That is, if the condition that the swelling pressure at the current time point is greater than or equal to a preset threshold value with reference to time series data of the swelling pressure stored in the storage unit 304 and at least one peak is identified in the differential voltage profile g'(t,V) is met, the control unit 303 may diagnose that there is a sign of core collapse of the electrode assembly JR and outputs a diagnosis result.

In this embodiment, the sign of core collapse of the electrode assembly JR may be detected in advance faster than when the sign of core collapse of the electrode assembly JR is detected using the swelling pressure profile f(t,p) or the differential swelling pressure profile f'(t,p). If the sign of core collapse of the electrode assembly JR occurs, the close contact state between the electrode and the separator near the core deteriorates before the swelling pressure changes appear, and the effective area where electrochemical reactions occur decreases, which may cause the change in which the voltage of the battery slightly decreases and then increases as shown by the dotted line profile in FIG. 6g.

The above minute voltage change may be detected by monitoring whether a peak appears in the differential voltage profile g'(t,V). For example, as shown in FIG. 6g, if a minute voltage decrease pattern occurs in the voltage profile g(t,V) at the t*_{diag} time point, a minimal peak may appear at the t*_{diag,1} time point in the differential voltage profile g'(t,V) before t*_{diag} time point, and a maximum peak may appear at the t*_{diag,2} time point after the t*_{diag} time point in the differential voltage profile g'(t,V). This is because, in the voltage profile g(t,V), an inflection point occurs at the t*_{diag,1} time point and the t*_{diag,2} time point before and after the t*_{diag} time point where the minimal peak appears. The t*_{diag} time point is a time point significantly earlier than the time point t_{diag} or t_{diag,1} at which the sign of core collapse of the electrode assembly JR is detected based on the swelling pressure profile f(t,p) or the differential swelling pressure profile f'(t,p). Therefore, the method of monitoring both the swelling pressure and the minute voltage change over time is more effective in diagnosing the sign of core collapse of the electrode assembly JR in advance.

The voltage profile g(t,V), which represents the voltage change over time, may be replaced with the voltage profile h(SOC, V), which represents the voltage change according to the state of charge (SOC) of the battery. In h(SOC, V), SOC is a variable representing SOC and V is a variable representing voltage.

The apparatus 300 for monitoring a swelling pressure of a cylindrical battery may further include a current measuring unit 308 to generate a voltage profile h(SOC, V). The current measuring unit 308 may include a current measurement circuit known in the art.

While the battery is being charged and discharged, the control unit 303 measures the charging current or the discharging current using the current measuring unit 308, determines the SOC of the battery using the ampere counting method, and accumulatively stores the SOC in the storage unit 304 along with a time stamp to generate time series data of the SOC in the storage unit 304.

The control unit 303 may generate a voltage profile h(SOC, V) indicating the change in voltage according to SOC by using the time series data of voltage and the time series data of SOC periodically stored in the storage unit 304.

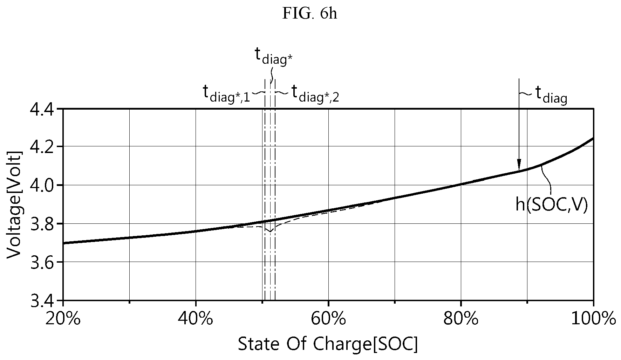

FIG. 6h is a graph showing a voltage profile h(SOC,V) according to another embodiment of the present disclosure.

The control unit 303 may periodically generate the differential voltage profile g'(SOC,V) through SOC differentiation with respect to the voltage profile h(SOC,V).

The control unit 303 may detect the sign of core collapse of the electrode assembly JR in advance using the differential voltage profile h'(SOC,V) that is periodically generated similar to the above embodiment.

That is, if the condition that the swelling pressure at the current time point is greater than or equal to the preset threshold value with reference to the time series data of the swelling pressure stored in the storage unit 304 and at least one peak is identified in the differential voltage profile h'(SOC,V) is met, the control unit 303 may diagnose that there is a sign of core collapse of the electrode assembly JR and outputs a diagnosis result.

In this embodiment, the sign of core collapse of the electrode assembly JR may be detected in advance faster than when the sign of core collapse of the electrode assembly JR is detected using the swelling pressure profile f(t,p) or the differential swelling pressure profile f'(t,p). If the sign of core collapse in the electrode assembly JR occurs, the close contact state between the electrode and the separator near the core deteriorates before the swelling pressure changes, and the effective area where electrochemical reactions occur decreases, which may cause the change in which the voltage of the battery slight decreases and then increases according to SOC as shown by the dotted line profile in FIG 6h.

The above minute voltage change may be detected by monitoring whether a peak appears in the differential voltage profile h'(SOC,V). For example, as shown in FIG. 6h, if a minute voltage decrease pattern occurs in the voltage profile h(SOC,V) at the t*_{diag} time point, in the differential voltage profile h'(SOC,V), a minimal peak may appear at the t*_{diag,1} time point before the t*_{diag} time point and a maximum peak may appear at the t*_{diag,2} time point after the t*_{diag} time point. This is because, in the voltage profile h(SOC,V), an inflection point occurs at the t*_{diag,1} time point and the t*_{diag,2} time point before and after the t*_{diag} time point where the minimal peak appears. The t*_{diag} time point is a time point significantly earlier than time point t_{diag} or t_{diag,1} at which the sign of core collapse of the electrode assembly JR is detected based on the swelling pressure profile f(t,p) or the differential swelling pressure profile f'(t,p). Therefore, the method of monitoring a swelling pressure and a minute voltage change according to SOC together is more effective in diagnosing the sign of core collapse of the electrode assembly JR in advance.

In still another aspect, the control unit 303 may visually output the diagnosis results of the embodiments through the display unit 305. The display unit 305 is provided in a device that receives power from a battery, and may be a known display such as LCD or OLED. The device may be an electric vehicle, and the display unit 305 may be an integrated display provided in the electric vehicle. However, the present disclosure is not limited by the type of device.

In still another aspect, the control unit 303 may transmit the diagnosis results of the embodiments to another computer system 310 through the communication unit 306. The communication unit 306 is a communication interface that may exchange data signals with an external device and may be a communication modem. The communication modem may support wired communication or wireless communication. The computer system 310 may be a diagnosis device. The diagnosis device may be provided at a service center that may professionally perform battery inspection and diagnosis.

The diagnosis result may include a warning message or a diagnosis request message. The warning message may include information notifying the user that a safety problem has occurred in the battery. The inspection request message may include a request to the user to diagnose the safety of the battery. If the user receives the warning message or the diagnosis request message, the user may visit a service center specialized in inspecting devices equipped with batteries to inspect the battery closely and replace the battery if it is confirmed that the core of the electrode assembly has collapsed.

The control unit 303 may read the time series data of the swelling pressure from the storage unit 304 according to a control command and output the time series data through the display unit 305 or transmit the time series data to another computer system through the communication unit 306. The control command may be input from the battery diagnosis device through the communication unit 306. If the display unit 305 is a display that includes a touch sensor, the control command may be input directly through the display unit 305.

In the present disclosure, the control unit 303 may optionally include a processor, an application-specific integrated circuit (ASIC), other chipsets, logic circuits, registers, communication modems, data processing devices, etc. known in the art to execute the various control logics described above. Also, when the control logic is implemented as software, the control unit 303 may be implemented as a set of program modules. At this time, the program module may be stored in a memory and executed by the processor. The memory may be provided inside or outside the processor, and may be connected to the processor by various well-known computer components. Also, the memory may be included in the storage unit 304 of the present disclosure. Also, the memory generically refers to a device that stores information regardless of the type of device, and does not refer to a specific memory device.

One or more of the various control logics of the control unit 303 are combined, and the combined control logics may be written in a computer-readable code system and recorded on a computer-readable recording medium. The type of the recording medium is not particularly limited as long as it can be accessed by a processor included in a computer. As an example, the recording medium includes at least one selected from the group including a ROM, a RAM, a register, a CD-ROM, a magnetic tape, a hard disk, a floppy disk, and an optical data recording device. In addition, the code system may be distributed, stored and executed in computers connected through a network. In addition, functional programs, codes and code segments for implementing the combined control logics may be easily inferred by programmers in the art to which the present disclosure belongs.

In the present disclosure, the storage unit 304 may include at least one type of storage media among flash memory type, hard disk type, SSD type (Solid State Disk type), SDD type (Silicon Disk Drive type), multimedia card micro type, RAM (random access memory), SRAM (static random access memory), ROM (read-only memory), EEPROM (electrically erasable programmable read-only memory), and PROM (programmable read-only memory).

The storage unit 304 may store data and programs required for calculation operations by the control unit 303. The storage unit 304 may store data representing the results of an operation performed by the control unit 303. In particular, the control unit 303 may accumulatively record the time series data of the swelling pressure determined by processing the RF signal transmitted from the pressure sensor (Pₛₑₙₛₒᵣ) and/or the time series data of the voltage of the battery and/or the time series data of the charge and discharge current of the battery and/or the time series data of the SOC of the battery in the storage unit 304.

In the present disclosure, a plurality of cylindrical batteries including the pressure sensor (Pₛₑₙₛₒᵣ) may be connected in series and/or parallel to form a battery pack.

To reduce costs, it is possible to include the pressure sensor (Pₛₑₙₛₒᵣ) in only some of the cylindrical batteries of the battery pack.

The apparatus 300 for monitoring a swelling pressure of a cylindrical battery may be included in a battery management system that controls charging and discharging of the battery pack on the whole.

The battery management system may diagnose the sign of core collapse of the electrode assembly in advance by periodically monitoring the swelling pressure change according to time and, optionally, the voltage change according to time or SOC for cylindrical battery(s) including a pressure sensor among the cylindrical batteries included in the battery pack by using the apparatus 300 for monitoring a swelling pressure, and output the diagnosis result through the display unit 305 or transmit the diagnosis result to another computer system through the communication unit 306.

In the above embodiments, components named '... unit' may be implemented as an electronic circuit. Anyone skilled in the art may easily design an electronic circuit by recognizing the functions of the components. Also, the components of the device should be understood as functionally distinct elements rather than physically distinct elements. Thus, each component may be selectively integrated with other components or each component may be divided into sub-components for efficient execution of control logic(s). However, it is obvious to those skilled in the art that even if the components are integrated or divided, if the same function can be recognized, the integrated or divided components should also be interpreted as falling within the scope of the present disclosure.

Next, the remaining features of the cylindrical battery according to an embodiment of the present disclosure will be described in detail.

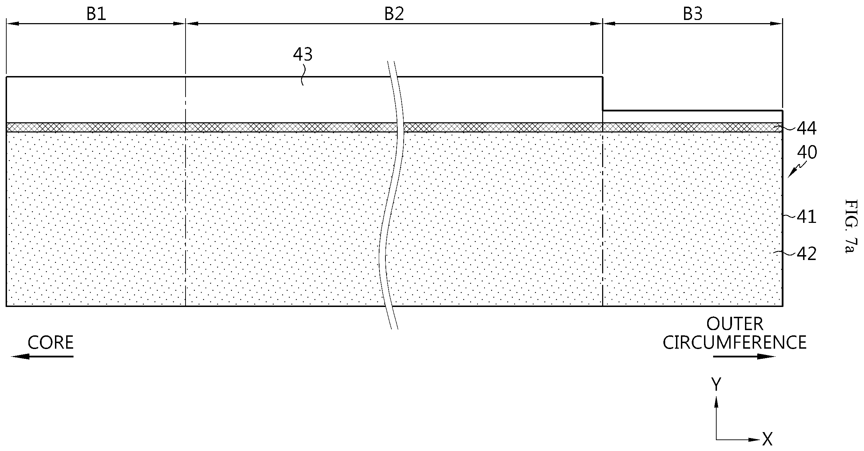

FIG. 7a is a plan view showing a structure of an electrode 40 according to an embodiment of the present disclosure.

Referring to FIG. 7a, the electrode 40 includes a current collector 41 made of metal foil and an active material layer 42. The metal foil may be a conductive metal, such as aluminum or copper, and is appropriately selected depending on the polarity of the electrode 40. The active material layer 42 is formed on at least one surface of the current collector 41. The active material layer 42 is formed along the winding direction X. The electrode 40 includes an uncoated portion 43 at the long side end in the winding direction X. The uncoated portion 43 is a partial region of the current collector 41 that is not coated with the active material. The area of the current collector 41 where the active material layer 42 is formed may be named an active material portion.

In the electrode 40, the width of the active material portion in the short side direction of the current collector 41 may be 50 mm to 120 mm, and the length of the active material portion in the long side direction of the current collector 41 may be 3 m to 5 m. Accordingly, the ratio of the short side to the long side of the active material portion may be 1.0% to 4.0%.

Preferably, in the electrode 40, the width of the active material portion in the short side direction of the current collector 41 may be 60 mm to 70 mm, and the length of the active material portion in the long side direction of the current collector 41 may be 3 m to 5 m. Accordingly, the ratio of the short side to the long side of the active material portion may be 1.2% to 2.3%.

The ratio of the short side to the long side of the active material portion is significantly smaller than the level of 6% to 11%, which is the ratio of the short side to the long side of the active material portion of an electrode used in a cylindrical battery with a form factor of 1865 or 2170.

Preferably, an insulation coating layer 44 may be formed at the boundary between the active material layer 42 and the uncoated portion 43. The insulation coating layer 44 is formed so that at least a part thereof overlaps the boundary between the active material layer 42 and the uncoated portion 43. The insulation coating layer 44 prevents short circuit between two electrodes having different polarities and facing each other with a separator interposed therebetween. The insulation coating layer 44 may cover the boundary between the active material layer 42 and the uncoated portion 43 with a width of 0.3 mm to 5 mm.

The uncoated portion 43 includes a core side uncoated portion B1 adjacent to the core of the electrode assembly, an outer circumference side uncoated portion B3 adjacent to the outer circumference of the electrode assembly, and an intermediate uncoated portion B2 interposed between the core side uncoated portion B1 and the outer circumference side uncoated portion B3.

The core side uncoated portion B1, the outer circumference side uncoated portion B3, and the intermediate uncoated portion B3 may be defined as an uncoated portion of an area adjacent to the core, an uncoated portion of an area adjacent to the outer circumference, and an uncoated portion of the remaining area excluding them, respectively, when the electrode 40 is wound into a jelly-roll type electrode assembly.

Hereinafter, the core side uncoated portion B1, the outer circumference side uncoated portion B3, and the intermediate uncoated portion B2 are referred to as a first portion, a second portion, and a third portion, respectively.

The height of the uncoated portion 43 is not constant and there is a relative difference in the winding direction X. That is, the height (length in the Y-axis direction) of the second portion B3 is greater than 0, but is relatively smaller than that of the first portion B1 and the third portion B2. In the winding direction X, the third portion B2 is longer than the first portion B1 and the second portion B3.

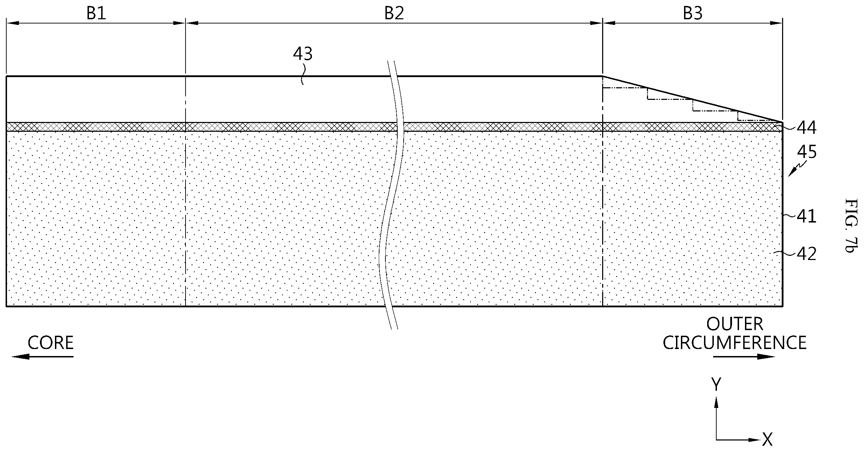

FIG. 7b is a plan view showing the structure of an electrode 45 according to another embodiment of the present disclosure.

Referring to FIG. 7b, the structure of the electrode 45 is substantially the same as the structure of the electrode 40 described above, except that that the height of the second portion B3 gradually decreases toward the outer circumference.

In one modification, the second portion B3 may be modified into a step shape (see dotted line) in which the height decreases step by step.

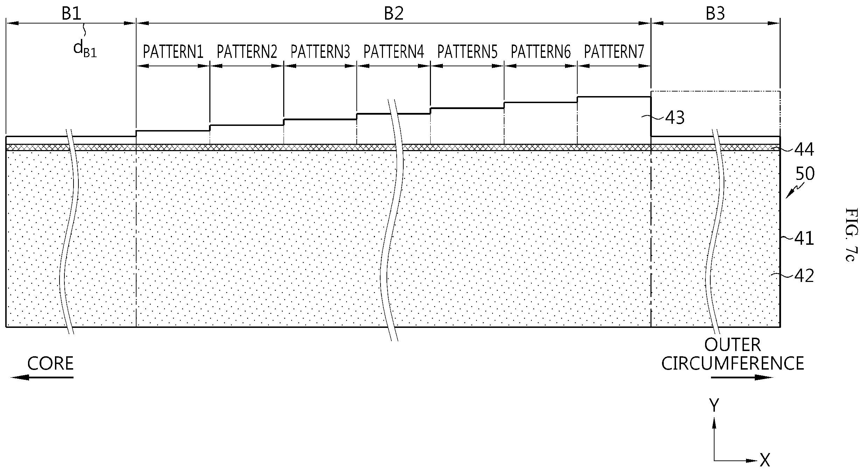

FIG. 7c is a plan view showing the structure of an electrode 50 according to still another embodiment of the present disclosure.

Referring to FIG. 7c, the height of the first portion B1 and the second portion B3 of the electrode 50 is greater than or equal to 0, but is relatively smaller than the height of the third portion B2. Also, the heights of the first portion B1 and the second portion B3 may be the same or different from each other.

Preferably, the height of the third portion B2 may have a step shape that increases stepwise from the core toward the outer circumference.

Patterns 1 to 7 divide the third portion B2 based on the position where the height of the uncoated portion 43 changes. Preferably, the number of patterns and the height (length in the Y-axis direction) and width (length in the X-axis direction) of each pattern may be adjusted to maximize stress distribution during the bending process of the uncoated portion 43. The stress distribution is to prevent tearing of the uncoated portion 43 when the uncoated portion 43 is bent toward the core of the electrode assembly.

The width (d_{B1}) of the first portion B1 is designed by applying the condition that the core of the electrode assembly is not covered when the patterns of the third portion B2 are bent toward the core. The core refers to the cavity that exists in the center of the electrode assembly.

In one example, the width (d_{B1}) of the first portion B1 may increase in proportion to the bending length of Pattern 1. The bending length corresponds to the height of the pattern relative to the bending point of the pattern.

Preferably, the width (d_{B1}) of the first portion B1 may be set so that the radial width of the winding turns formed by the first portion B1 is equal to or greater than the bending length of Pattern 1.

In a specific example, when the electrode 50 is used to manufacture an electrode assembly of a cylindrical battery with a form factor of 4680, the width (d_{B1}) of the first portion B1 may be set as 180 mm to 350 mm depending on the diameter of the core of the electrode assembly and the bending length of Pattern 1.

In one modification, the height of the third portion B2 may have a step shape that increases and then decreases from the core toward the outer circumference.

In another modification, the second portion B3 may be modified to have the structure of the electrode 45 of FIG. 7b.

In still another modification, the pattern structure applied to the third portion B2 may be extended to the second portion B3 (see dotted line).

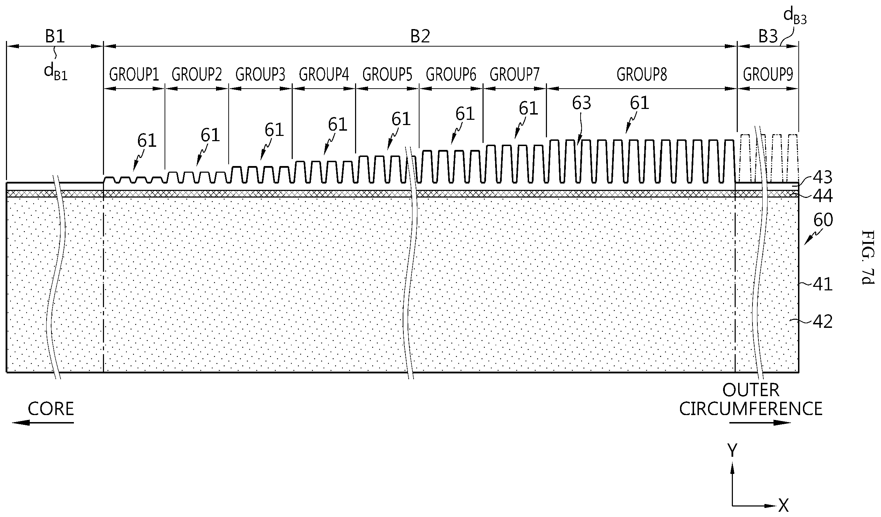

FIG. 7d is a plan view showing the structure of an electrode 60 according to still another embodiment of the present disclosure.

Referring to FIG. 7d, in the electrode 60, the height of the first portion B1 and the second portion B3 in the winding axis Y direction is greater than or equal to 0, but is relatively smaller than the height of the third portion B2. Also, the height of the first portion B1 and the second portion B3 in the winding axis Y direction may be the same or different.

Preferably, the third portion B2 may include a plurality of segments 61 in at least a partial section. The height of the plurality of segments 61 may increase stepwise from the core toward the outer circumference. The plurality of segments 61 have a geometric shape whose width decreases from the bottom to the top. Preferably, the geometric shape is a trapezoidal shape. The geometric shape may be modified in various ways, such as square, parallelogram, semicircle, and semi-elliptic shapes.

The segment 61 may be notched with a laser. The segment 61 may be formed by a known metal foil cutting process such as ultrasonic cutting or punching.

In one aspect, the plurality of segments 61 may form a plurality of segment groups from the core toward the outer circumference. At least one of width, height, and separation pitch of segments belonging to the same segment group may be substantially the same. Preferably, the width, height, and separation pitch of segments belonging to the same segment group may be the same.

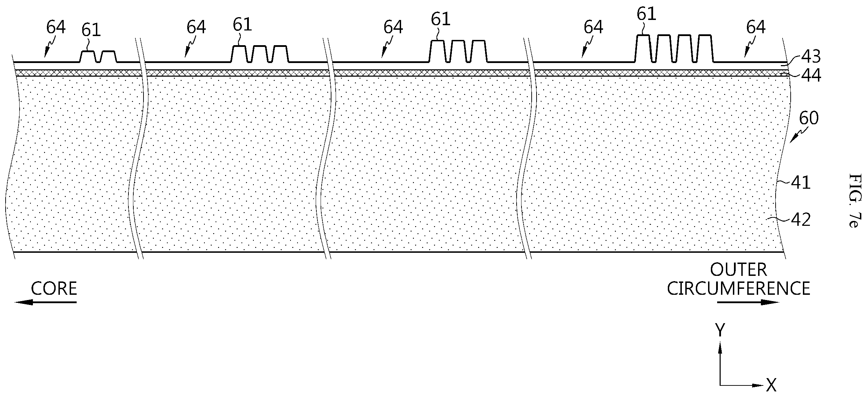

When the uncoated portion 43 of the electrode 60 has a segment structure, the electrode 60 may include a segment skip region 64 in which some of the plurality of segments are regularly or irregularly omitted, as shown in FIG. 7e.

Preferably, the segment skip region 64 may be plural. In one example, the width of the segment skip region 64 may be constant from the core toward the outer circumference. In another example, the width of the segment skip region 64 may increase or decrease regularly or irregularly from the core toward the outer circumference. Preferably, the height of the uncoated portion present in the segment skip region 64 may correspond to the height of the first portion B1 and/or the second portion B3.

The number of segments 61 existing between the segment skip regions 64 may be at least one. As shown in FIG. 7e, the electrode 60 may include an uncoated portion section in which the number of segments 61 existing between the segment skip regions 64 increases from the core toward the outer circumference.

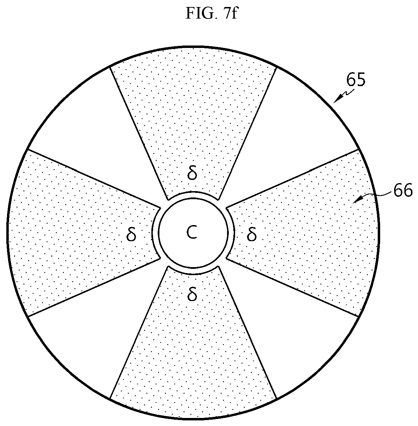

Preferably, the width of the segment skip region 64 may be set such that when the electrode 60 is wound as shown in FIG. 7f, the segments located at each winding turn may be located within a preset independent area 66 based on the core center C of the electrode assembly 65.

In other words, the plurality of segments 61 may be located within the plurality of independent areas 66 based on the center of the core C when looking at the electrode assembly 65 in the winding axis direction. The number of independent areas 66 may be changed to 2, 3, 4, 5, etc.

Preferably, the independent area 66 may be fan-shaped. In this case, the angle between the independent areas 66 may be substantially the same. Also, the circumferential angle (δ) of the independent area 66 may be 20 degrees or more, optionally 25 degrees or more, optionally 30 degrees or more, optionally 35 degrees or more, or optionally 40 degrees or more.

In a modification, the independent area 66 may have a geometric shape such as square, rectangle, quadrilateral, and trapezoid.

According to still another aspect of the present disclosure, after the electrode 60 is wound into the electrode assembly, the segments exposed at the top and bottom of the electrode assembly may overlap in several layers along the radial direction of the electrode assembly to form a bending surface region.

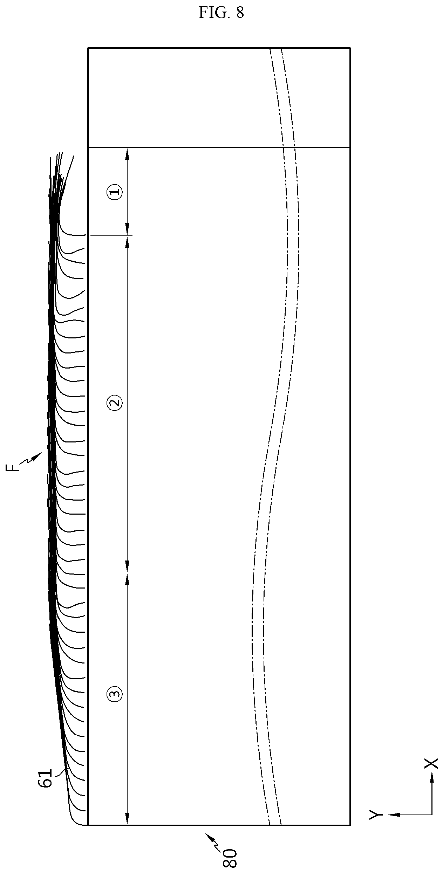

FIG. 8 is a schematic diagram showing a cross section of a bending surface region F formed by bending the segment 61 toward the core C of the electrode assembly 80 according to an embodiment of the present disclosure. In FIG. 8, the cross section of the bending surface region F only at the left side is shown based on the winding axis of the electrode assembly 80. The bending surface region F may be formed on both the top and bottom of the electrode assembly 80.

Referring to FIG. 8, the bending surface region F has a structure in which the segments 61 overlap in a plurality of layers in the winding axis direction. The overlapping direction is the winding axis direction Y. Section ① is a segment skip region (first portion B1) with no segments, and the sections ② and ③ are sections where the winding turn containing the segments 61 is located. Section ② is a height variable section in which the height of the segment 61 is variable, and the section ③ is a height uniform section in which the height of the segment is maintained uniformly up to the outer circumference of the electrode assembly. As will be described later, the radial lengths of the sections ② and ③ may be variable. Meanwhile, the uncoated portion (second portion B3) included in at least one winding turn including the outermost winding turn may not include a segment structure.

Preferably, the number of stacks of the segments 61 at each position of the bending surface region F may be designed to be 10 or more to match the required welding strength of the current collector by adjusting the height, width, and separation pitch of the segments 61 according to the radius of the winding turn including the segments 61.

The electrode structures of the above embodiments (modifications) may be applied to at least one of the first electrode and the second electrode with different polarities included in the jelly-roll type electrode assembly. Also, when the electrode structure of the embodiments (modifications) is applied to one of the first electrode and the second electrode, a conventional electrode structure may be applied to the other electrode. Also, the electrode structures applied to the first electrode and the second electrode may not be the same but be different.

For example, when the first electrode and the second electrode are a positive electrode and a negative electrode, respectively, one of the embodiments (modifications) may be applied to the first electrode and a conventional electrode structure (see FIG. 1) may be applied to the second electrode.

As another example, when the first electrode and the second electrode are a positive electrode and a negative electrode, respectively, one of the embodiments (modifications) may be selectively applied to the first electrode, and another one of the embodiments (modifications) may be selectively applied to the second electrode.

In the present disclosure, a positive electrode active material coated on the positive electrode and a negative electrode active material coated on the negative electrode may employ any active material known in the art without limitation.

In one example, the positive electrode active material may include an alkali metal compound expressed by a general formula A[AₓM_{y}]O_{2+z} (A includes at least one element among Li, Na and K; M includes at least one element selected from is Ni, Co, Mn, Ca, Mg, Al, Ti, Si, Fe, Mo, V, Zr, Zn, Cu, Mo, Sc, Zr, Ru, and Cr; 0 ≤ x, 1 ≤ x+y ≤2, -0.1 ≤ z ≤ 2; and the stoichiometric coefficients x, y and z are selected so that the compound maintains electrical neutrality).

In another example, the positive electrode active material may be an alkali metal compound xLiM¹O₂-(1-x)Li₂M²O₃ disclosed in US6,677,082, US6,680,143, et al., wherein M¹ includes at least one element having an average oxidation state 3; M² includes at least one element having an average oxidation state 4; and 0≤x≤1).

In still another example, the positive electrode active material may be lithium metal phosphate expressed by a general formula LiₐM¹ₓFe₁₋ₓM²_{y}P_{1-y}M³_{z}O_{4-z} (M¹ includes at least one element selected from the Ti, Si, Mn, Co, Fe, V, Cr, Mo, Ni, Nd, Mg and Al; M² includes at least one element selected from Ti, Si, Mn, Co, Fe, V, Cr, Mo, Ni, Nd, Mg, Al, As, Sb, Si, Ge, V and S; M³ includes a halogen element optionally including F; 0 < a ≤2, 0 ≤ x ≤ 1, 0 ≤ y < 1, 0 ≤ z < 1; the stoichiometric coefficient a, x, y, and z are selected so that the compound maintains electrical neutrality), or Li₃M₂(PO₄)₃ [M includes at least one element selected from Ti, Si, Mn, Fe, Co, V, Cr, Mo, Ni, Mg and Al].

Preferably, the positive electrode active material may include primary particles and/or secondary particles in which the primary particles are aggregated.

In one example, the negative electrode active material may employ carbon material, lithium metal or lithium metal compound, silicon-based compound, tin or tin compound, or the like. Metal oxides such as TiO₂ and SnO₂ with a potential of less than 2V may also be used as the negative electrode active material. As the carbon material, low-crystalline carbon, high-crystalline carbon or the like may be used.

The separator may employ a porous polymer film, for example, a porous polymer film made of a polyolefin-based polymer such as ethylene homopolymer, propylene homopolymer, ethylene/butene copolymer, ethylene/hexene copolymer, ethylene/methacrylate copolymer, or the like, or laminates thereof. As another example, the separator may employ a common porous nonwoven fabric, for example, a nonwoven fabric made of high melting point glass fiber, polyethylene terephthalate fiber, or the like.

At least one surface of the separator may include a coating layer of inorganic particles. It is also possible that the separator itself is made of a coating layer of inorganic particles. The particles constituting the coating layer may have a structure coupled with a binder so that interstitial volumes exist among adjacent particles.

The inorganic particles may be made of an inorganic material having a dielectric constant of 5 or more. The inorganic particles may include at least one material selected from the group consisting of Pb(Zr,Ti)O₃ (PZT), Pb₁₋ₓLaₓZr_{1-y}Ti_{y}O₃ (PLZT), PB(Mg₃Nb_{2/3})O₃, PbTiO₃ (PMN-PT), BaTiO₃, hafnia (HfO₂), SrTiO₃, TiO₂, Al₂O₃, ZrO₂, SnO₂, CeO₂, MgO, CaO, ZnO and Y₂O₃.

In the present disclosure, the cylindrical battery may be, for example, a cylindrical battery whose form factor ratio (defined as a value obtained by dividing the diameter of the cylindrical battery by height, namely a ratio of diameter (Φ) to height (H)) is greater than about 0.4. Here, the form factor means a value indicating the diameter and height of a cylindrical battery.

Preferably, the cylindrical battery may have a diameter of 40 mm to 50 mm and a height of 60 mm to 130 mm. The form factor of the cylindrical battery according to an embodiment of the present disclosure may be, for example, 46110, 4875, 48110, 4880, or 4680. In the numerical value representing the form factor, first two numbers indicate the diameter of the battery, and the remaining numbers indicate the height of the battery. The winding turn of the electrode assembly may be 50 turns to 60 turns.

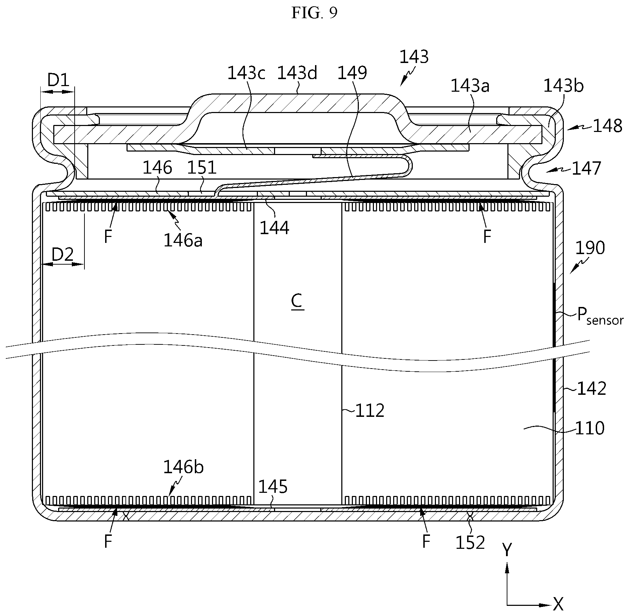

FIG. 9 is a cross-sectional view showing a cylindrical battery 190 according to an embodiment of the present disclosure, taken along the Y-axis direction.

Referring to FIG. 9, the cylindrical battery 190 according to an embodiment of the present disclosure includes an electrode assembly 110 having a first electrode, a separator and a second electrode, a battery housing 142 for accommodating the electrode assembly 110, and a sealing body 143 for sealing an open end of the battery housing 142.

The battery housing 142 is a cylindrical container with an opening at the top. The battery housing 142 is made of a conductive metal material such as aluminum, steel or stainless steel. A nickel coating layer may be formed on the surface of the battery housing 142. The battery housing 142 accommodates the electrode assembly 110 in the inner space through the top opening and also accommodates the electrolyte.

The electrode assembly 110 may be manufactured by winding a laminate formed by sequentially laminating a lower separator, a first electrode, an upper separator, and a second electrode at least once, based on the winding axis C, as shown in FIG. 2.

The first electrode and the second electrode have different polarities. That is, if one has positive polarity, the other has negative polarity. At least one of the first electrode and the second electrode may have an electrode structure according to the above embodiments (modifications). In addition, another of the first electrode and the second electrode may have a conventional electrode structure or an electrode structure according to embodiments (modifications). The electrode pair included in the electrode assembly 110 is not limited to one electrode pair, two or more electrode pairs may be included.

The pressure sensor (Pₛₑₙₛₒᵣ) may be interposed between the outer circumference of the electrode assembly 110 and the inner circumference of the battery housing 142. The configuration and installation location of the pressure sensor (Pₛₑₙₛₒᵣ) have already been described in detail. The pressure sensor (Pₛₑₙₛₒᵣ) may sense the swelling pressure applied by the outer circumference of the electrode assembly 110 to the inner circumference of the battery housing 142 and transmit a pressure sensing signal to the apparatus 300 for monitoring a swelling pressure (FIG. 6e) at the outside through wireless communication.

The first uncoated portion 146a of the first electrode and the second uncoated portion 146b of the second electrode protrude at the upper portion and the lower portion of the electrode assembly 110, respectively. The first uncoated portion 146a and the second uncoated portion 146b may be bent toward the core of the electrode assembly 110 to form a bending surface region F. The second portion B3 of the first electrode is spaced apart from the inner circumference of the battery housing 142, particularly the beading portion 147, by a predetermined distance. Therefore, the second portion B3 of the first electrode does not come into contact with the battery housing 142 electrically connected to the second electrode, thereby preventing an internal short circuit.

The second uncoated portion 146b of the second electrode may have substantially the same structure as the first uncoated portion 146a. In another modification, the second uncoated portion 146b may selectively have the uncoated portion structures of the electrodes according to the embodiments (modifications).

The sealing body 143 may include a cap 143a having a plate shape, a sealing gasket 143b for providing airtightness between the cap 143a and the battery housing 142 and having insulation, and a connection plate 143c electrically and mechanically coupled to the cap 143a.

The cap 143a is a component made of a conductive metal material, and covers the top opening of the battery housing 142. The cap 143a is electrically connected to the uncoated portion 146a of the first electrode, and is electrically insulated from the battery housing 142 by means of the sealing gasket 143b. Accordingly, the cap 143a may function as the first electrode (for example, positive electrode) of the cylindrical battery 190.

The cap 143a is placed on the beading portion 147 formed on the battery housing 142, and is fixed by a crimping portion 148. Between the cap 143a and the crimping portion 148, the sealing gasket 143b may be interposed to secure the airtightness of the battery housing 142 and the electrical insulation between the battery housing 142 and the cap 143a. The cap 143a may have a protrusion 143d protruding upward from the center thereof.

The battery housing 142 is electrically connected to the second uncoated portion 146b of the second electrode. Therefore, the battery housing 142 has the same polarity as the second electrode. If the second electrode has negative polarity, the battery housing 142 also has negative polarity.

The battery housing 142 includes the beading portion 147 and the crimping portion 148 at the top thereof. The beading portion 147 is formed by press-fitting the periphery of the outer circumferential surface of the battery housing 142. The beading portion 147 prevents the electrode assembly 110 accommodated inside the battery housing 142 from escaping through the top opening of the battery housing 142, and may function as a support portion on which the sealing body 143 is placed.

The inner circumference of the beading portion 147 may be spaced apart from the second portion B3 of the first electrode by a predetermined interval. More specifically, the lower end of the inner circumference of the beading portion 147 is separated from the second portion B3 of the first electrode by a predetermined interval. In addition, since the second portion B3 has a low height, the second portion B3 is not substantially affected even when the battery housing 142 is pressed inward at the outside to form the beading portion 147. Therefore, the second portion B3 is not pressed by other components such as the beading portion 147, and thus partial shape deformation of the electrode assembly 110 is prevented, thereby preventing a short circuit inside the cylindrical battery 190.

Preferably, when the pressing depth of the beading portion 147 is defined as D1 and the radial length from the inner circumference of the battery housing 142 to the boundary point between the second portion B3 and the third portion B2 is defined as D2, the relational expression D1 ≤ D2 may be satisfied. In this case, when pressing inward the battery housing 142 to form the beading portion 147, it is possible to substantially prevent the second portion B3 from being damaged.

The crimping portion 148 is formed on the beading portion 147. The crimping portion 148 has an extended and bent shape to cover the outer circumference of the cap 143a disposed on the beading portion 147 and a part of the upper surface of the cap 143a.

The cylindrical battery 190 may further include a first current collector 144 and/or a second current collector 145 and/or an insulator 146.

The first current collector 144 is coupled to the upper portion of the electrode assembly 110. The first current collector 144 is made of a conductive metal material such as aluminum, copper, steel, nickel and so on, and is electrically connected to the first uncoated portion 146a of the first electrode. The electric connection may be made by welding. A lead 149 may be connected to the first current collector 144. The lead 149 may extend upward above the electrode assembly 110 and be coupled to the connection plate 143c or directly coupled to the lower surface of the cap 143a. The lead 149 may be connected to other components by welding.

Preferably, the first current collector 144 may be integrally formed with the lead 149. In this case, the lead 149 may have an elongated plate shape extending outward from near the center of the first current collector 144.

The first current collector 144 is coupled to the bending surface region F of the first uncoated portion 146a. The bending surface region F of the first uncoated portion 146a and the first current collector 144 may be coupled by, for example, laser welding. Laser welding may be performed by partially melting a base material of the current collector 144. The laser welding may be replaced with resistance welding, ultrasonic welding, spot welding, or the like.

The second current collector 145 may be coupled to the lower surface of the electrode assembly 110. One side of the second current collector 145 may be coupled by welding to the bending surface region F of the second uncoated portion 146b, and the other side may be coupled to the inner bottom surface of the battery housing 142 by welding. The coupling structure between the second current collector 145 and the second uncoated portion 146b may be substantially the same as the coupling structure between the first current collector 144 and the first uncoated portion 146a.

If the first current collector 144 and the second current collector 145 are welded to the bending surface regions F of the first uncoated portion 146a and the second uncoated portion 146b, respectively, it is possible to prevent the electrodes from rotating when the electrode assembly 110 swells. This effect appears identically in embodiments described later.

The uncoated portions 146a, 146b are not limited to the illustrated structure. Accordingly, the uncoated portions 146a, 146b may selectively have a conventional uncoated portion structure as well as the electrode uncoated portion structure according to the embodiments (modifications).

The insulator 146 may cover the first current collector 144. The insulator 146 may cover the first current collector 144 at the upper surface of the first current collector 144, thereby preventing direct contact between the first current collector 144 and the inner circumference of the battery housing 142.

The insulator 146 has a lead hole 151 so that the lead 149 extending upward from the first current collector 144 may be withdrawn therethrough. The lead 149 is drawn upward through the lead hole 151 and coupled to the lower surface of the connection plate 143c or the lower surface of the cap 143a.

A peripheral region of the edge of the insulator 146 may be interposed between the first current collector 144 and the beading portion 147 to fix the coupled body of the electrode assembly 110 and the first current collector 144. Accordingly, the movement of the coupled body of the electrode assembly 110 and the first current collector 144 may be restricted in the winding axis direction Y of the battery 190, thereby improving the assembly stability of the battery 190.

The insulator 146 may be made of an insulating polymer resin. In one example, the insulator 146 may be made of polyethylene, polypropylene, polyimide, or polybutylene terephthalate.

The battery housing 142 may further include a venting portion 152 formed at a lower surface thereof. The venting portion 152 corresponds to a region having a smaller thickness compared to the peripheral region of the lower surface of the battery housing 142. The venting portion 152 is structurally weak compared to the surrounding area. Accordingly, when an abnormality occurs in the cylindrical battery 190 and the internal pressure increases to a predetermined level or more, the venting portion 152 may be ruptured so that the gas generated inside the battery housing 142 is discharged to the outside.

The venting portion 152 may be formed continuously or discontinuously while drawing a circle at the lower surface of the battery housing 142. In one modification, the venting portion 152 may be formed in a straight pattern or other patterns.

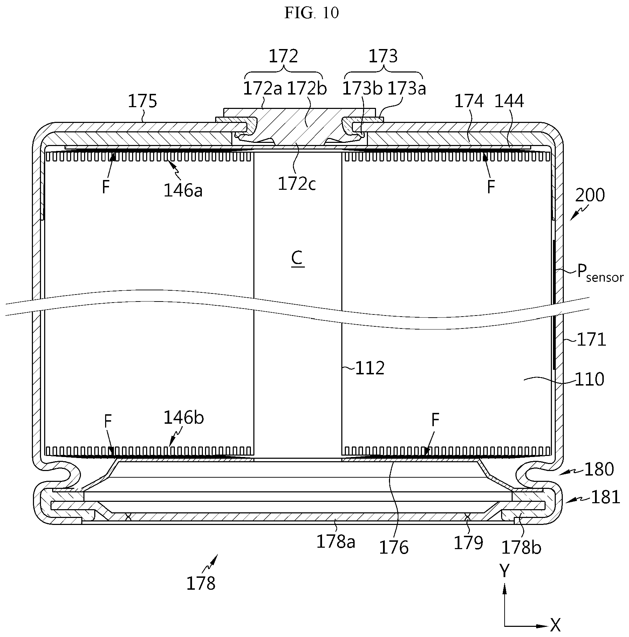

FIG. 10 is a cross-sectional view showing a cylindrical battery 200 according to an embodiment of the present disclosure, taken along the Y-axis.

Referring to FIG. 10, the structure of the electrode assembly of the cylindrical battery 200 is substantially the same as that of the cylindrical battery 190 of in FIG. 9, and the other structure except for the electrode assembly is changed.

The cylindrical battery 200 includes a pressure sensor (Pₛₑₙₛₒᵣ). The pressure sensor (Pₛₑₙₛₒᵣ) may be interposed between the outer circumference of the electrode assembly 110 and the inner circumference of the battery housing 171. The configuration and installation location of the pressure sensor (Pₛₑₙₛₒᵣ) have already been described in detail. The pressure sensor (Pₛₑₙₛₒᵣ) may sense the swelling pressure applied by the outer circumference of the electrode assembly 110 to the inner circumference of the battery housing 171 and transmit a pressure sensing signal to the apparatus 300 for monitoring a swelling pressure (FIG. 6e) at the outside through wireless communication.

The cylindrical battery 200 includes a battery housing 171 through which a terminal 172 is installed. The terminal 172 is installed through a perforation hole formed in the closed surface (the upper surface in the drawing) of the battery housing 171. The terminal 172 is riveted to the perforation hole of the battery housing 171 in a state where an insulating gasket 173 made of an insulating material is interposed therebetween. The terminal 172 is exposed to the outside in a direction opposite to the direction of gravity.

The terminal 172 may be a rivet terminal that includes a terminal exposing portion 172a and a terminal insert portion 172b. The terminal exposing portion 172a is exposed to the outside of the closed surface of the battery housing 171. The terminal exposing portion 172a may be located approximately at a central portion of the closed surface of the battery housing 171. The maximum diameter of the terminal exposing portion 172a may be larger than the maximum diameter of the perforation hole formed in the battery housing 171. The terminal insert portion 172b may be electrically connected to the uncoated portion 146a of the first electrode through approximately the central portion of the closed surface of the battery housing 171. The lower edge of the terminal insert portion 172b may be riveted onto the inner surface of the battery housing 171. That is, the lower edge of the terminal insert portion 172b may have a shape curved toward the inner surface of the battery housing 171. A flat portion 172c is included at the inner side of the lower edge of the terminal insert portion 172b. The maximum diameter of the lower portion of the riveted terminal insert portion 172b may be larger than the maximum diameter of the perforation hole of the battery housing 171.

The flat portion 172c of the terminal insert portion 172b may be welded to the center portion of the first current collector 144 connected to the first uncoated portion 146a of the first electrode. The welding may be replaced with other welding methods such as ultrasonic welding.

An insulator 174 made of an insulating material may be interposed between the first current collector 144 and the inner surface of the battery housing 171. The insulator 174 covers the upper portion of the first current collector 144 and the top edge of the electrode assembly 110. Accordingly, it is possible to prevent the first uncoated portion 146a of the electrode assembly 110 and the inner circumference of the battery housing 171 having different polarities from contacting and causing a short circuit.

The thickness of the insulator 174 corresponds to or is slightly greater than the distance between the upper surface of the first current collector 144 and the inner surface of the closed portion of the battery housing 171. Accordingly, the insulator 174 may contact the upper surface of the first current collector 144 and the inner surface of the closed portion of the battery housing 171.

The terminal insert portion 172b of the terminal 172 may be welded to the first current collector 144 through the perforation hole of the insulator 174. A diameter of the perforation hole formed in the insulator 174 may be larger than a diameter of the riveting portion at the lower end of the terminal insert portion 172b. Preferably, the perforation hole may expose the lower portion of the terminal insert portion 172b and the insulating gasket 173.

The insulating gasket 173 is interposed between the battery housing 171 and the terminal 172 to prevent the battery housing 171 and the terminal 172 having opposite polarities from electrically contacting each other. Accordingly, the upper surface of the battery housing 171 having an approximately flat shape may function as the second electrode (for example, negative electrode) of the cylindrical battery 200.

The insulating gasket 173 includes a gasket exposing portion 173a and a gasket insert portion 173b. The gasket exposing portion 173a is interposed between the terminal exposing portion 172a of the terminal 172 and the battery housing 171. The gasket insert portion 173b is interposed between the terminal insert portion 172b of the terminal 172 and the battery housing 171. The gasket insert portion 173b may be deformed together when the terminal insert portion 172b is riveted, so as to be in close contact with the inner surface of the battery housing 171. The insulating gasket 173 may be made of, for example, a polymer resin having insulation property.

The gasket exposing portion 173a of the insulating gasket 173 may have an extended shape to cover the outer circumference of the terminal exposing portion 172a of the terminal 172. When the insulating gasket 173 covers the outer circumference of the terminal 172, it is possible to prevent a short circuit from occurring while an electrical connection part such as a bus bar is coupled to the upper surface of the battery housing 171 and/or the terminal 172. Although not shown in the drawings, the gasket exposing portion 173a may have an extended shape to cover not only the outer circumference surface of the terminal exposing portion 172a but also a part of the upper surface thereof.

When the insulating gasket 173 is made of a polymer resin, the insulating gasket 173 may be coupled to the battery housing 171 and the terminal 172 by thermal fusion. In this case, airtightness at the coupling interface between the insulating gasket 173 and the terminal 172 and at the coupling interface between the insulating gasket 173 and the battery housing 171 may be enhanced. Meanwhile, when the gasket exposing portion 173a of the insulating gasket 173 has a shape extending to the upper surface of the terminal exposing portion 172a, the terminal 172 may be integrally coupled with the insulating gasket 173 by insert injection molding.

In the upper surface of the battery housing 171, a remaining area 175 other than the area occupied by the terminal 172 and the insulating gasket 173 corresponds to the second electrode terminal having a polarity opposite to that of the terminal 172.

The second current collector 176 is coupled to the lower portion of the electrode assembly 110. The second current collector 176 is made of a conductive metal material such as aluminum, steel, copper or nickel, and is electrically connected to the second uncoated portion 146b of the second electrode.

Preferably, the second current collector 176 is electrically connected to the battery housing 171. To this end, at least a portion of the edge of the second current collector 176 may be interposed and fixed between the inner surface of the battery housing 171 and a sealing gasket 178b. In one example, at least a portion of the edge of the second current collector 176 may be fixed to the beading portion 180 by welding in a state of being supported on the lower surface of the beading portion 180 formed at the bottom of the battery housing 171. In one modification, at least a portion of the edge of the second current collector 176 may be directly welded to the inner circumference of the battery housing 171.

Preferably, the second current collector 176 and the bending surface region F of the second uncoated portion 146b may be coupled by welding, for example laser welding. In addition, the welded portion of the second current collector 176 and the second uncoated portion 146b may be spaced apart by a predetermined interval toward the core C based on the inner circumference of the beading portion 180.

A sealing body 178 for sealing the lower open end of the battery housing 171 includes a cap 178a having a plate shape and a sealing gasket 178b. The sealing gasket 178b electrically separates the cap 178a and the battery housing 171. A crimping portion 181 fixes the edge of the cap 178a and the sealing gasket 178b together. The cap 178a has a venting portion 179. The configuration of the venting portion 179 is substantially the same as the above embodiment (modification). The lower surface of the cap 178a may be located above the lower end of the crimping portion 181. In this case, a space is formed under the cap 178a to smoothly perform venting. In particular, it is useful when the cylindrical battery 200 is installed so that the crimping portion 181 faces the direction of gravity.

Preferably, the cap 178a is made of a conductive metal material. However, since the sealing gasket 178b is interposed between the cap 178a and the battery housing 171, the cap 178a does not have electrical polarity. The sealing body 178 seals the open end of the lower portion of the battery housing 171 and mainly functions to discharge gas when the internal pressure of the battery 200 increases over a critical value.

Preferably, the terminal 172 electrically connected to the first uncoated portion 146a of the first electrode is used as the first electrode terminal. In addition, in the upper surface of the battery housing 171 electrically connected to the second uncoated portion 146b of the second electrode through the second current collector 176, a part 175 except for the terminal 172 is used as the second electrode terminal having a different polarity from the first electrode terminal. If two electrode terminals are located at the upper portion of the cylindrical battery 200 as above, it is possible to arrange electrical connection components such as bus bars at only one side of the cylindrical battery 200. This may bring about simplification of the battery pack structure and improvement of energy density. In addition, since the part 175 used as the second electrode terminal has an approximately flat shape, a sufficient connection area may be secured for connecting electrical connection components such as bus bars. Accordingly, the cylindrical battery 200 may reduce the resistance at the connection portion of the electrical connection components to a desirable level.

The cylindrical battery 200 according to an embodiment of the present disclosure have an advantage in that electrical connection can be performed at the upper portion thereof.

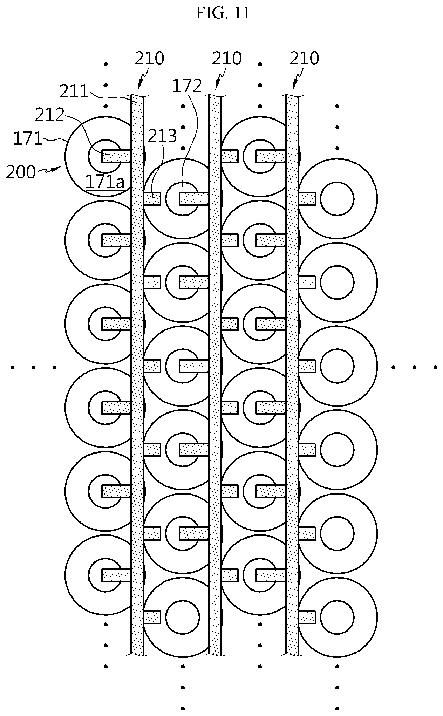

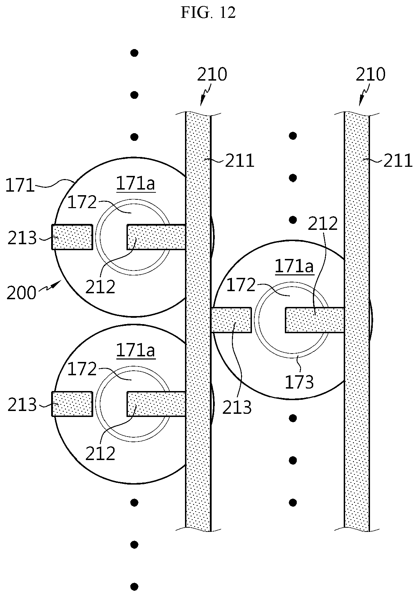

FIG. 11 is a top plan view illustrating a state in which a plurality of cylindrical batteries 200 are electrically connected according to an embodiment of the present disclosure, and FIG. 12 is a partially enlarged view of FIG. 11.

Referring to FIGS. 11 and 12, a plurality of cylindrical batteries 200 may be connected in series and in parallel at an upper portion of the cylindrical batteries 200 using a bus bar 210. The number of cylindrical batteries 200 may be increased or decreased in consideration of the capacity of the battery pack.

In each cylindrical battery 200, the terminal 172 may have a positive polarity, and the flat surface 171a around the terminal 172 of the battery housing 171 may have a negative polarity, or vice versa.

Preferably, the plurality of cylindrical batteries 200 may be arranged in a plurality of columns and rows. Columns are provided in a vertical direction on the drawing, and rows are provided in a left and right direction on the drawing. In addition, in order to maximize space efficiency, the cylindrical batteries 200 may be arranged in a closest packing structure. The closest packing structure is formed when an equilateral triangle is formed by connecting the centers of the terminals 172 exposed out of the battery housing 171 to each other. Preferably, the bus bar 210 connects the cylindrical batteries 200 arranged in the same column in parallel to each other, and connects the cylindrical batteries 200 arranged in two neighboring columns in series with each other.

Preferably, the bus bar 210 may include a body portion 211, a plurality of first bus bar terminals 212 and a plurality of second bus bar terminals 213 for serial and parallel connection.

The body portion 211 may extend along the column of the cylindrical batteries 200 between neighboring terminals 172. Alternatively, the body portion 211 may extend along the column of the cylindrical batteries 200, and the body portion 211 may be regularly bent like a zigzag shape.

The plurality of first bus bar terminals 212 may extend in one side direction of the body portion 211 and may be electrically coupled to the terminal 172 of the cylindrical battery 200 located in one side direction. The electrical connection between the first bus bar terminal 212 and the terminal 172 may be achieved by laser welding, ultrasonic welding, or the like.

The plurality of second bus bar terminals 213 may extend in the other side direction of the body portion 211 and may be electrically coupled to the flat surface 171a around the terminal 172 located in the other side direction. The electrical coupling between the second bus bar terminal 213 and the flat surface 171a may be performed by laser welding, ultrasonic welding, or the like.

Preferably, the body portion 211, the plurality of first bus bar terminals 212 and the plurality of second bus bar terminals 213 may be made of one conductive metal plate. The metal plate may be, for example, an aluminum plate or a copper plate, but the present disclosure is not limited thereto. In a modified example, the body portion 211, the plurality of first bus bar terminals 212 and the second bus bar terminals 213 may be manufactured as separate pieces and then coupled to each other by welding or the like.

The cylindrical battery 200 of the present disclosure as described above has a structure in which resistance is minimized by enlarging the welding region by means of the bending surface region F, multiplexing current paths by means of the second current collector 176, minimizing a current path length, or the like. The AC resistance of the cylindrical battery 200 measured through a resistance meter between the positive electrode and the negative electrode, namely between the terminal 172 and the flat surface 171a around the terminal 172, may be approximately 0.5 milliohms to 4 milliohms, preferably 1 milliohms to 4 milliohms, suitable for fast charging.

In the cylindrical battery 200 according to the present disclosure, since the terminal 172 having a positive polarity and the flat surface 171a having a negative polarity are located in the same direction, it is easy to electrically connect the cylindrical batteries 200 using the bus bar 210.

In addition, since the terminal 172 of the cylindrical battery 200 and the flat surface 171a around the terminal 172 have a large area, the coupling area of the bus bar 210 may be sufficiently secured to sufficiently reduce the resistance of the battery pack including the cylindrical battery 200.

In addition, since electrical wiring may be performed on the upper portion of the cylindrical battery 200, there is an advantage in maximizing the energy density per unit volume of the battery module/pack.

The cylindrical battery according to the above embodiments (modifications) may be used to manufacture a battery pack.

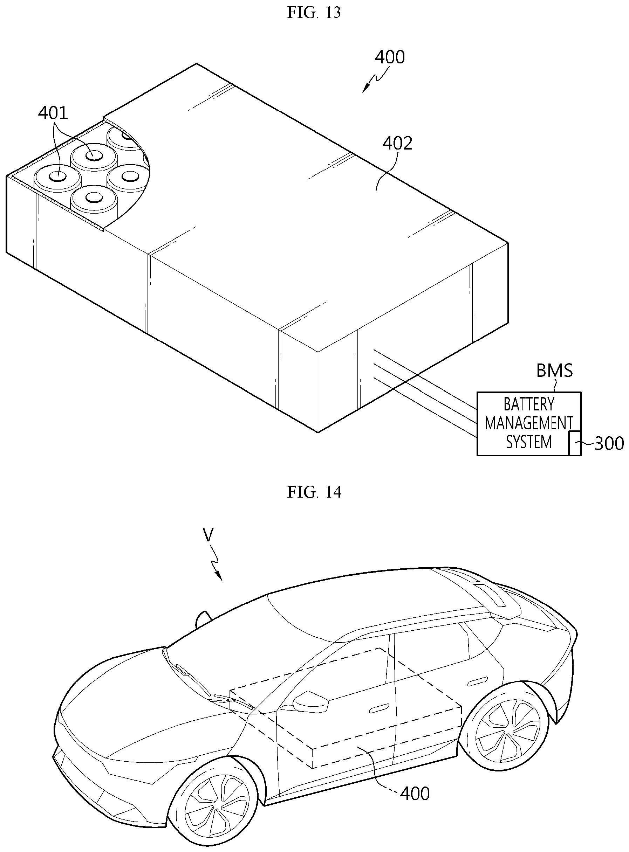

FIG. 13 is a diagram schematically showing a battery pack according to an embodiment of the present disclosure.

Referring to FIG. 13, a battery pack 400 according to an embodiment of the present disclosure includes an aggregate in which cylindrical batteries 401 are electrically connected, and a pack housing 402 for accommodating the aggregate. The cylindrical battery 401 may be any one of the batteries according to the above embodiments (modifications). In the drawing, components such as a bus bar for electrical connection of the cylindrical batteries 401, a cooling unit, and an external terminal are not depicted for convenience of illustration.

The plurality of cylindrical batteries 401 may include the pressure sensor (Pₛₑₙₛₒᵣ) according to an embodiment of the present disclosure. Optionally, only some of the plurality of cylindrical batteries 401 may include the pressure sensor (Pₛₑₙₛₒᵣ) according to an embodiment of the present disclosure.

The battery pack 400 may be operably coupled with a battery management system (BMS). The battery management system (BMS) may control the charging and discharging of the battery pack 400, calculate and monitor operation parameters such as SOC (State Of Charge), SOH (State Of Health), available power, and the like, and perform protection operations such as overcurrent/overcharge/overdischarge blocking.

The battery management system (BMS) may include the apparatus 300 for monitoring a swelling pressure according to an embodiment of the present disclosure. The apparatus 300 for monitoring a swelling pressure may collect a pressure sensing signal through wireless communication from a cylindrical battery including the pressure sensor (Pₛₑₙₛₒᵣ) to generate time series data of the swelling pressure applied by the outer circumference of the electrode assembly to the inner circumference of the battery housing, diagnose the sign of core collapse of the electrode assembly using the time series data of the swelling pressure and, optionally, time series data of voltage, and output the diagnosis result visually through a display unit or transmit the diagnosis result to another computer system through a communication unit.

The battery pack 400 may be mounted to a vehicle. The vehicle may be, for example, an electric vehicle, a hybrid electric vehicle, or a plug-in hybrid vehicle. The vehicle includes a four-wheeled vehicle or a two-wheeled vehicle.

FIG. 14 is a diagram schematically showing a vehicle including the battery pack 400 of FIG. 13.

Referring to FIG. 14, a vehicle V according to an embodiment of the present disclosure includes the battery pack 400 according to an embodiment of the present disclosure. The vehicle V operates by receiving power from the battery pack 400 according to an embodiment of the present disclosure.

According to an aspect of the present disclosure, it is possible to prevent or alleviate the core from collapsing by maintaining the symmetry and circularity of the electrode assembly even if swelling phenomenon occurs by adjusting relative positions of a positive electrode end and a negative electrode end at the core and the outer circumference of the electrode assembly of the cylindrical battery.

According to another embodiment of the present disclosure, since a pressure sensor capable of transmitting a pressure sensing signal through wireless communication is included inside the cylindrical battery to continuously monitor the change in the swelling pressure that the outer circumference of the electrode assembly applies to the inner circumference of the battery housing, the sign of core collapse may be easily detected.

According to still another embodiment of the present disclosure, a battery pack manufactured using the cylindrical battery including a pressure sensor and a vehicle including the same may be provided.

According to still another embodiment of the present disclosure, an apparatus capable of monitoring the change in swelling pressure applied by the outer circumference of the electrode assembly to the inner circumference of the battery housing while a cylindrical battery is being charged and discharged and detecting the sign of core collapse of the electrode assembly, and a battery management system including the same may be provided.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

## Claims

1. A cylindrical battery, comprising:
an electrode assembly in which a first electrode, a second electrode, and a separator interposed therebetween are wound based on a winding axis to define a core and an outer circumference;
a battery housing having an open end and a closed portion opposing thereto, configured to accommodate the electrode assembly in a space between the open end and the closed portion, and electrically connected to one of the first electrode and the second electrode to have a first polarity;
a sealing body configured to seal the open end of the battery housing;
a terminal electrically connected to another of the first electrode and the second electrode to have a second polarity and having a surface exposed to an outside; and
a pressure sensor interposed between an outer circumference of the electrode assembly and an inner circumference of the battery housing and configured to sense a swelling pressure applied by the outer circumference of the electrode assembly to the inner circumference of the battery housing and output a pressure sensing signal to the outside.

2. The cylindrical battery according to claim 1,
wherein the pressure sensor is formed in a sheet shape and is joined to the outer circumference of the electrode assembly along the shape of the outer circumference of the electrode assembly.

3. The cylindrical battery according to claim 1,
wherein the first electrode includes a first active material portion coated with an active material layer and a first uncoated portion not coated with an active material layer along a winding direction, and the second electrode includes a second active material portion coated with an active material layer and a second uncoated portion not coated with an active material layer along the winding direction,
wherein the first uncoated portion and the second uncoated portion are exposed to the outside of the separator to face each other along the winding axis direction and are defined by themselves as electrode tabs, and
wherein when a winding turn portion disposed between two straight lines connecting a center of the core to a core side end of the first active material portion and a core side end of the second active material portion on a cross section of the electrode assembly perpendicular to the winding axis direction is defined as a stress vulnerable region and a winding turn portion disposed between two straight lines connecting the center of the core to an outer circumference side end of the first active material portion and an outer circumference side end of the second active material portion is defined as a stress amplification region, the stress amplification region is spaced apart from the stress vulnerable region along a circumferential direction of the electrode assembly on the cross section.

4. The cylindrical battery according to claim 3,
wherein the pressure sensor is interposed between the outer circumference of the electrode assembly and the inner circumference of the battery housing to cover at least a part of the stress amplification region.

5. The cylindrical battery according to claim 4,
wherein the first electrode and the second electrode are a positive electrode and a negative electrode, respectively,
wherein the outer circumference side end of the second electrode is located closer to the outer circumference of the electrode assembly than the outer circumference side end of the first electrode,
wherein the separator is interposed between the outer circumference side end of the second electrode and the outer circumference side end of the first electrode,
wherein the outer circumference side end of the second electrode extends in the circumferential direction of the electrode assembly to pass through the outer circumference side end of the first electrode along the winding direction of the electrode assembly, and
wherein the pressure sensor is interposed between the outer circumference of the electrode assembly and the inner circumference of the battery housing to intersect a straight line connecting the center of the core and the outer circumference side end of the first electrode.

6. The cylindrical battery according to claim 1,
wherein the pressure sensor outputs the pressure sensing signal to the outside through wireless communication.

7. The cylindrical battery according to claim 3, further comprising:
a first bending surface region formed by bending the first uncoated portion of the first electrode toward the core;
a first current collector coupled to the first bending surface region;
a second bending surface region formed by bending the second uncoated portion of the second electrode toward the core; and
a second current collector coupled to the second bending surface region.

8. The cylindrical battery according to claim 7,
wherein the sealing body includes:
a cap electrically connected to the first current collector;
a crimping portion bent in a centripetal direction of the electrode assembly while surrounding an edge of the cap to fix the edge of the cap to the open end of the battery housing; and
a sealing gasket interposed between the crimping portion and the edge of the cap to seal the open end of the battery housing.

9. The cylindrical battery according to claim 7, further comprising:
a rivet terminal riveted to an inner surface of the closed portion while passing through a perforation hole formed in the closed portion of the battery housing; and
an insulating gasket interposed between the rivet terminal and an inner circumference of the perforation hole to electrically insulate the rivet terminal and the battery housing,
wherein the terminal with a second polarity is the rivet terminal.

10. The cylindrical battery according to claim 9, further comprising:
a beading portion formed by indenting the outer circumference of the battery housing adjacent to the open end of the battery housing toward the winding axis direction, and
wherein at least a part of an edge of the second current collector contacts the beading portion.

11. The cylindrical battery according to claim 10, further comprising:
a crimping portion formed by bending the open end of the battery housing toward the winding axis direction,
wherein the sealing body includes a cap seated on the beading portion; and a sealing gasket interposed between an edge of the cap and the open end of the battery housing, and
wherein one surface of the sealing gasket is in close contact with the edge of the cap by the crimping portion, and another surface of the sealing gasket is in close contact with the edge of the second current collector in contact with the beading portion by the crimping portion.

12. The cylindrical battery according to claim 1,
wherein a ratio of diameter to height of the cylindrical battery is greater than 0.4.

13. The cylindrical battery according to claim 1,
wherein the cylindrical battery has a form factor of 46110, 4875, 48110, 4880, or 4680.

14. A battery pack, comprising the cylindrical battery according to any one of claims 1 to 13.

15. A vehicle, comprising the battery pack according to claim 14.

16. An apparatus for monitoring a swelling pressure of a cylindrical battery, which includes an electrode assembly in which a first electrode, a second electrode, and a separator interposed therebetween are wound based on a winding axis to define a core and an outer circumference; a battery housing having an open end and a closed portion opposing thereto, configured to accommodate the electrode assembly in a space between the open end and the closed portion, and electrically connected to one of the first electrode and the second electrode to have a first polarity; a sealing body configured to seal the open end of the battery housing; a terminal electrically connected to another of the first electrode and the second electrode to have a second polarity and having a surface exposed to an outside; and a pressure sensor interposed between an outer circumference of the electrode assembly and an inner circumference of the battery housing and configured to sense a swelling pressure applied by the outer circumference of the electrode assembly to the inner circumference of the battery housing and output a pressure sensing signal to the outside through wireless communication, the apparatus comprising:
a receiving unit configured to receive the pressure sensing signal transmitted from the pressure sensor through wireless communication;
a signal processing unit configured to demodulate the pressure sensing signal into an original signal; and
a control unit configured to determine a swelling pressure from the demodulated pressure sensing signal and generate time series data of the swelling pressure.

17. The apparatus for monitoring a swelling pressure of a cylindrical battery according to claim 16,
wherein the pressure sensor is configured to transmit a reference surface acoustic wave and a sensing surface acoustic wave having a different amplitude from the reference surface acoustic wave according to the swelling pressure through wireless communication, and
wherein the control unit is configured to determine an amplitude difference between the reference surface acoustic wave and the sensing surface acoustic wave and determine a swelling pressure corresponding to the determined amplitude difference using a predefined correlation between the amplitude difference and the swelling pressure.

18. The apparatus for monitoring a swelling pressure of a cylindrical battery according to claim 16,
wherein the control unit is configured to generate a swelling pressure profile from the time series data of the swelling pressure, and when at least one minimal peak is identified in the swelling pressure profile, the control unit is configured to diagnoses that there is a sign of core collapse of the electrode assembly and output a diagnosis result.

19. The apparatus for monitoring a swelling pressure of a cylindrical battery according to claim 16,
wherein the control unit is configured to generate a swelling pressure profile from the time series data of the swelling pressure, generate a differential swelling pressure profile through time differentiation of the swelling pressure profile, diagnose that there is a sign of core collapse of the electrode assembly when at least one peak is identified in the differential swelling pressure profile, and output the diagnosis result.

20. The apparatus for monitoring a swelling pressure of a cylindrical battery according to claim 16, further comprising:
a voltage measuring unit configured to measure voltage of the cylindrical battery,
wherein the control unit is configured to:
generate a voltage profile by periodically receiving a voltage measurement value from the voltage measuring unit,
generate a differential voltage profile through time or SOC differentiation for the voltage profile, and
diagnose that there is a sign of core collapse of the electrode assembly when the swelling pressure is greater than or equal to a threshold value and at least one peak is identified in the differential voltage profile, and output the diagnosis result.

21. The apparatus for monitoring a swelling pressure of a cylindrical battery according to any one of claims 18 to 20, further comprising:
a display unit operably coupled with the control unit,
wherein the control unit is configured to output the diagnosis result through the display unit.

22. The apparatus for monitoring a swelling pressure of a cylindrical battery according to any one of claims 18 to 20, further comprising:
a communication unit operably coupled with the control unit,
wherein the control unit is configured to transmit the diagnosis result to a computer system through the communication unit.

23. The apparatus for monitoring a swelling pressure of a cylindrical battery according to any one of claims 18 to 20,
wherein the diagnosis result includes a warning message or an inspection request message.

24. A battery management system, comprising the apparatus for monitoring a swelling pressure of a cylindrical battery according to any one of claims 16 to 23.
